(19) Europäisches Patentamt / European Patent Office / Office européen des brevets

(11) **EP 3 920 426 B1**

(12) **EUROPEAN PATENT SPECIFICATION**

(45) Date of publication and mention
of the grant of the patent:
**10.12.2025 Bulletin 2025/50**

(21) Application number: **20918068.6**

(22) Date of filing: **29.10.2020**

(51) International Patent Classification (IPC):
*H04B 1/76* *(2006.01)*   *H04L 27/36* *(2006.01)*
*H04B 1/04* *(2006.01)*

(52) Cooperative Patent Classification (CPC):
**H04B 1/0475; H03D 1/24; H04L 27/36;**
H03D 2200/0082; H04B 2001/0491

(86) International application number:
**PCT/CN2020/124655**

(87) International publication number:
**WO 2021/155681 (12.08.2021 Gazette 2021/32)**

(54) **SIDEBAND SUPPRESSION METHOD, APPARATUS AND COMPUTER DEVICE, AND STORAGE MEDIUM**

SEITENBANDUNTERDRÜCKUNGSVERFAHREN, VORRICHTUNG UND COMPUTERVORRICHTUNG UND SPEICHERMEDIUM

PROCÉDE DE SUPPRESSION DE BANDE LATÉRALE, APPAREIL ET DISPOSITIF INFORMATIQUE, ET SUPPORT DE STOCKAGE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **03.02.2020 CN 202010078701**

(43) Date of publication of application:
**08.12.2021 Bulletin 2021/49**

(73) Proprietor: **Tencent Technology (Shenzhen)
Company Limited
Shenzhen, Guangdong, 518057 (CN)**

(72) Inventors:
• **ZHANG, Zhenxing**
  **Shenzhen, Guangdong 518057 (CN)**
• **ZHANG, Shengyu**
  **Shenzhen, Guangdong 518057 (CN)**

(74) Representative: **Novagraaf International SA
Chemin de l'Echo 3
1213 Onex, Geneva (CH)**

(56) References cited:
EP-A2- 1 560 391     CN-A- 101 435 862
CN-A- 101 521 962     CN-A- 101 540 626
CN-A- 101 557 373     US-A- 5 396 196
US-A1- 2003 095 607     US-A1- 2004 082 305

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

This application claims priority to Chinese Patent Application No. 202010078701.2, entitled "SIDEBAND SUPPRESSION METHOD, APPARATUS AND COMPUTER DEVICE, AND STORAGE MEDIUM" filed with the China National Intellectual Property Administration on February 3, 2020.

**FIELD**

This application relates to the technical field of signal processing, and particularly to a sideband suppression method and apparatus, a computer device, and a storage medium.

**BACKGROUND**

To better transmit a signal, a carrier is usually used to transmit the signal. The carrier is a physical basis and a carrying tool for signal transmission. For example, generally, a signal to be transmitted has a low frequency, and if the signal is transmitted based on the frequency thereof, it is not conducive to reception of the signal. Therefore, the signal to be transmitted may be loaded on a signal of a carrier, and the signal loaded on the carrier may be transmitted.

In another aspect, evolution of a quantum state of a superconducting qubit is usually implemented by using a microwave signal. To obtain higher fidelity of a quantum gate operation, a shape of the microwave signal is usually modulated to a certain extent. At present, the signal may be modulated by a modulator, and a baseband signal and a carrier signal are used to generate a modulation signal of a final qubit.

However, due to non-ideality of a device itself, after the baseband signal is modulated, sidebands that are symmetrical to each other relative to the carrier is usually formed. A useless sideband occupies communication transmission resources, and leads to waveform distortion and reduced fidelity of the signal.

The patent application No. US2004082305A1 discloses systems and methods for a sideband suppression technique for quadrature modulation using magnitude measurements. Gain imbalance, phase imbalance, or both gain and phase imbalance are corrected in a quadrature modulator. Predetermined voltage levels are applied to one or both of the quadrature modulator input channels and resultant output magnitudes are measured. Then, a gain correction factor, a phase correction factor or both gain and a phase correction factors are determined as a function of the measured output magnitudes. Gain imbalance, phase imbalance or both gain and imbalance are then corrected using the gain and phase correction factors.

The patent application No. CN101540626A discloses a trans-receiver and a zero intermediate frequency emission calibrating method. The trans-receiver comprises a zero intermediate frequency emission circuit and a receiving circuit, and also comprises a coupling module and a calibration parameter adjusting module, wherein the coupling module is arranged between the zero intermediate frequency emission circuit and the receiving circuit, and is used for coupling radio-frequency signals of the emission circuit to the receiving circuit; and the calibration parameter adjusting module is arranged on the receiving circuit, used for adjusting unbalance factors of the coupled signals in a close loop to make the signal quality index meet the predetermined demand, and uses the adjusted unbalance factors as calibration parameters to calibrate the emission signals of the emission circuit. The method of the invention can adaptively adjust the calibration parameters of the zero intermediate frequency signals with lower cost according to environmental requirements.

**SUMMARY**

According to embodiments provided in this application, a sideband suppression method and apparatus, a computer device, and a storage medium are provided as disclosed in the independent claims. Further embodiments are presented in the dependent claims.

Details of one or more embodiments of this application are provided in the subsequent drawings and descriptions. Other features, objectives, and advantages of this application are illustrated in the specification, the drawings, and the claims.

**BRIEF DESCRIPTION OF THE DRAWINGS**

To describe technical solutions in embodiments of this application more clearly, the drawings required for describing the embodiments are briefly introduced in the following. Apparently, the drawings in the following description show only some embodiments of this application, and a person of ordinary skill in the art may derive other drawings from these drawings without creative efforts.

FIG. 1 is a diagram showing an application environment of a sideband suppression method according to some embodiments.

FIG. 2 is a flowchart of a sideband suppression method according to some embodiments.

FIG. 3 is a flowchart of a process for obtaining a target sideband suppression parameter based on a target signal related parameter according to some embodiments.

FIG. 4 is a flowchart of a process for obtaining a sideband suppression parameter corresponding to a reference signal related parameter in a parameter correspondence set according to some embodiments.

FIG. 5 is a flowchart of sideband calibration according to some embodiments.

FIG. 6 is a diagram of a connection relationship between devices during sideband calibration according to some embodiments.

FIG. 7 is a schematic diagram of a process for implementing signal sideband suppression according to some embodiments.

FIG. 8 is a diagram of an operation principle of a quadrature modulator with errors according to some embodiments.

FIG. 9A is a diagram of a comparison effect between other solutions and solutions of embodiments of this application according to some embodiments.

FIG. 9B is a diagram of a comparison effect between other solutions and solutions of embodiments of this application according to some embodiments.

FIG. 10 is a structural block diagram of a sideband suppression apparatus according to an embodiment.

FIG. 11 is a block diagram of an internal structure of a computer device according to some embodiments.

## DESCRIPTION OF EMBODIMENTS

To make the objectives, technical solutions, and advantages of this application clearer and more understandable, this application is further described in detail below with reference to the drawings and the embodiments. It is to be understood that the specific embodiments described herein are merely used for explaining this application but are not intended to limit this application.

It may be understood that the terms "first", "second" and the like used in this application may be used for describing various elements in this specification. However, the elements are not limited by the terms unless otherwise specified. The terms are merely used for distinguishing a first element from another element. For example, without departing from the scope of this application, a first suppression sideband may be referred to as a second suppression sideband, and similarly, the second suppression sideband may be referred to as the first suppression sideband.

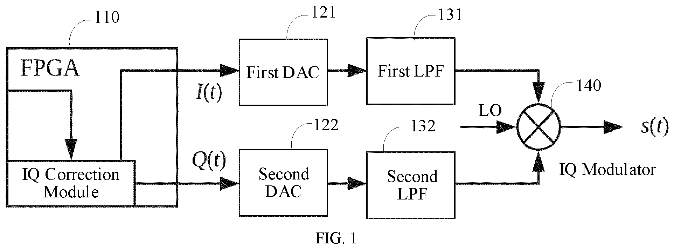

FIG. 1 is a diagram showing an application environment of a sideband suppression method according to some embodiments. As shown in FIG. 1, in this application environment, a quantum computer may correspond to a field programmable gate array (FPGA) 110, a first digital to analog converter (DAC) 121, a second DAC 122, a first low pass filter (LPF) 131, a second LPF 132, and an in-phase and quadrature phase (IQ) modulator 140. The IQ modulator is a four-port (including a port I, a port Q, a port LO, and a port RF) microwave device that may modulate microwave signals in quadrature. The port I and the port Q input baseband signals of medium and low frequencies. The port LO (local oscillator) inputs carrier signals. The port RF (radio frequency) outputs modulated signals. The computer may input to the FPGA a target baseband signal that is desired to be outputted, and correct the target baseband signal through an IQ correction module in the FPGA. In a case that a real part $I(t)$ and an imaginary part $Q(t)$ of the corrected signal pass through the DAC and the LPF, two corrected target baseband signals are obtained. The corrected target baseband signal corresponding to the real part is inputted to the port I of the IQ modulator, and the corrected target baseband signal corresponding to the imaginary part is inputted to the port Q of the IQ modulator. The port LO of the modulator is provided with a carrier for signal modulation, to obtain the modulated signal $s(t)$. $s(t)$ may be a signal used to modulate a superconducting qubit. t in $s(t)$, $I(t)$, and $Q(t)$ represents a time variable t, for example, $s(t)$ represents a modulation signal at the time t. The IQ correction module may be included in the FPGA to correct a baseband signal. The IQ correction module may be a module that implements an IQ compensation algorithm on hardware, and a signal correction algorithm provided in this embodiment of this application may also be referred to as the IQ compensation algorithm.

According to the method provided in this embodiment of this application, the target baseband signal may be corrected before the signal is modulated by the IQ modulator. Signal related parameters may include, for example, a frequency of a carrier, and a frequency and an amplitude of a baseband signal. For example, for any common signal $z_0(t)$, due to the non-ideality of the actual IQ modulator, there are often errors caused by one or more of IQ baseband amplitude imbalance $\rho_1$, IQ baseband phase imbalance $\kappa$, quadrature carrier amplitude imbalance $\rho_2$, or quadrature carrier phase imbalance $\lambda$, resulting in useless sidebands. Generally, such errors are not easily and directly measured. However, the inventor of this application found through actual measurement that the IQ baseband amplitude imbalance $\rho$ and the baseband phase imbalance $\kappa$ are not fixed, and usually change with signal related parameters corresponding to the baseband signal. For example, the IQ baseband amplitude imbalance $\rho$ and the baseband phase imbalance $\kappa$ are usually related to a frequency $f$ of the baseband signal and a baseband signal amplitude $A$ at the frequency of the baseband signal, and the carrier phase imbalance $\lambda$ is usually related to a carrier frequency $f_c$. Therefore, the inventor of this application found through calculation (the principle is described later) that a target sideband suppression parameter may be obtained based on the signal related parameters of the target baseband signal, such as the frequency $f$, the amplitude $A$ of the baseband signal, or the carrier frequency $f_c$. Based on the target sideband suppression parameter, the target baseband signal is pre-processed to obtain a corrected target baseband signal. After the signal correction based on the target sideband suppression parameter, a difference $\Delta S$ between the corrected target baseband signal and the target baseband signal may offset the errors caused by the non-ideality of the IQ modulator as much as possible, thereby suppressing a signal corresponding to a useless sideband in the modulation signal obtained by modulation as much as possible.

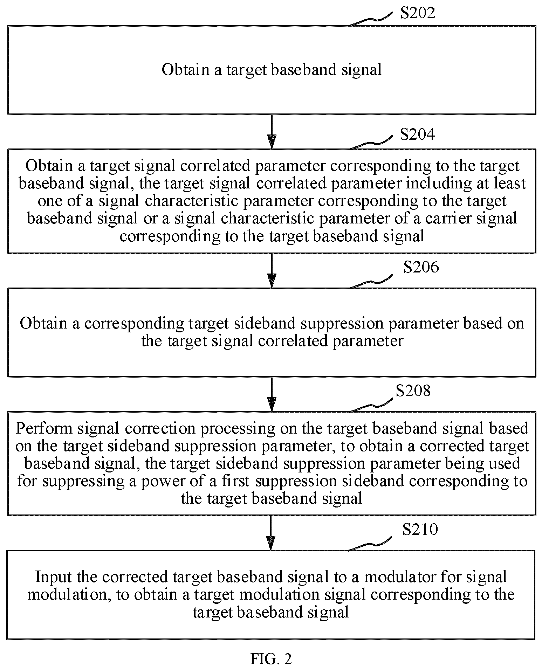

As shown in FIG. 2, in some embodiments, a sideband suppression method is provided. This embodiment is described mainly by taking an example in which the method is applied to the foregoing quantum computer. The method may further include the following steps S202 to S210.

In step S202, a target baseband signal is obtained.

Specifically, the target baseband signal is a baseband signal that needs to be modulated, and the baseband signal may be an original electric signal sent by a signal source which is not modulated. The computer sends a digital signal corresponding to the baseband signal to a Digital Analog Converter, and the Digital Analog Converter (121 and 122 in FIG. 1) generate continuous analog signals based on the digital signal. The signals may be used as baseband signals.

In step S204, a target signal related parameter corresponding to the target baseband signal is obtained. The target signal related parameter includes at least one of a signal characteristic parameter corresponding to the target baseband signal or a signal characteristic parameter of a carrier signal corresponding to the target baseband signal.

Specifically, the signal related parameter is a parameter related to the target baseband signal. A signal characteristic parameter is a parameter related to a characteristic of a baseband signal, and the signal characteristic parameter may include at least one of a frequency of the signal, an amplitude of the signal, or a time length of the signal. For example, a frequency and a signal amplitude of the target baseband signal, and a frequency of a carrier may be obtained as target signal related parameters.

The carrier signal has a waveform used for modulation to transmit a signal, and may be a sinusoidal signal. The modulation refers to a process of loading a baseband signal to be transmitted on the carrier signal, that is, a process of adding the baseband signal to the carrier to perform spectrum transmission. The purpose of modulation may be to transform the signal to be transmitted into a signal suitable for channel transmission, such as a high-frequency signal. The purpose of modulation may be to generate a high-frequency control signal based a medium-low frequency baseband signal. However, the high-frequency signal is not used for transmission purposes, but is used, for example, as a signal for controlling a superconducting qubit. Generally, a baseband signal is a low-frequency signal, and a carrier is a high-frequency signal.

In some embodiments, the target baseband signal obtained by the computer may be a target baseband signal in a time domain. Therefore, frequency domain transformation may be performed on the target baseband signal in the time domain to obtain a target baseband signal in a frequency domain, and a frequency and an amplitude of the target baseband signal in the frequency domain is obtained.

In step S206, a target sideband suppression parameter is obtained based on the target signal related parameter.

Specifically, the sideband suppression parameter is a parameter used for sideband suppression. The sideband suppression parameter may be obtained by performing parameter adjustment with a purpose of decreasing a power of a signal corresponding to a sideband that needs to be suppressed, for example, the power of the sideband that needs to be suppressed corresponding to the sideband suppression parameter is less than a preset power threshold. Therefore, by processing the signal using a sideband suppression parameter, the power of the signal corresponding to the sideband that needs to be suppressed may be decreased. A correspondence set of signal related parameters and sideband suppression parameters may be preset, such as a correspondence table of signal related parameters and sideband suppression parameters. Therefore, in a case of obtaining the target signal related parameter, the computer may obtain a sideband suppression parameter corresponding to the target signal related parameter based on the pre-stored correspondence table of the signal related parameters and the sideband suppression parameters.

There may a direct correspondence or an indirect correspondence between the target sideband suppression parameter and the target signal related parameter. The direct correspondence means that there is a sideband suppression parameter corresponding to the target signal related parameter in the correspondence set. For example, for a target signal related parameter $a$, there are the target signal related parameter $a$ and a sideband suppression parameter corresponding to the target signal related parameter $a$ in the correspondence set. The indirect correspondence means that there is no sideband suppression parameter directly corresponding to the target signal related parameter in the correspondence set. Because signal related parameters corresponding to the baseband signal in different scenarios are different from each other, there may result in a heavy workload if all sideband suppression parameters corresponding to the signal related parameters are pre-determined. Therefore, the target sideband suppression parameter corresponding to the target signal related parameter may be obtained by performing interpolation based on the correspondence in the correspondence set. In another example, the target signal related parameter needs to be transformed to obtain a transformed target signal related parameter. A sideband suppression parameter corresponding to the transformed target signal related parameter is obtained. The target sideband suppression parameter corresponding to the target signal related parameter is obtained based on the sideband suppression parameter corresponding to the transformed target signal related parameter. For example, it is assumed that the target sideband suppression parameter includes a frequency $f$ of the target baseband signal, the frequency of the target compensation signal needs to be transformed to $-f$. In this case, the target sideband suppression parameter with the transformed frequency $-f$, that is, the frequency $-f$ needs to be obtained first, and then an initial compensation signal is processed. In a case that the target compensation signal is obtained, the baseband signal is compensated.

In some embodiments, the target sideband suppression parameter may be a real number or a complex number. Because a signal may generally be represented by a complex number, the target sideband suppression parameter may be a complex number.

In step S208, signal correction is performed on the target baseband signal based on the target sideband suppression parameter, to obtain a corrected target baseband signal, the target sideband suppression parameter is used for suppressing a power of a first suppression sideband corresponding to the target baseband signal.

Specifically, if the modulated signal is not processed, a frequency band is generated on each of upper and lower sides of a center carrier frequency, and the frequency bands on the upper and lower sides are referred to as sidebands. The first suppression sideband is a sideband that needs to be suppressed in a modulation signal corresponding to the target baseband signal, that is, a useless sideband. For example, in a case that a baseband signal with a frequency of $f$ is modulated by using a carrier with a frequency of $f_c$, a modulation signal outputted includes a frequency component of $f_c - f$ and a frequency component of $f_c + f$. That is, there are sidebands that are symmetrical to the carrier and that are caused due to the non-ideality of the device. In an ideal situation, only a sideband of the frequency $f_c - f$ is desired, and the sideband of the frequency $f_c + f$ is a useless sideband caused by the non-ideality of the actual device. For example, in an application of a superconducting qubits, the modulated signal usually needs to have a frequency close to a frequency corresponding to an energy level difference between two energy levels $|0\rangle$, $|1\rangle$ of the superconducting qubit, and a typical frequency corresponding to the modulated signal is around 6 GHz. Therefore, it is generally desired that the frequency of the carrier is within a range of several hundred MHz centered on the frequency of the qubit. Therefore, the useless sideband with $f_c + f$ not only occupies transmission resources, but also results in signal distortion, which causes additional excitation to the superconducting qubits and affects the accuracy of a quantum gate operation.

The corrected target baseband signal is obtained by performing signal correction on the target baseband signal. The correction processing may include at least one of adding a compensation signal to the target baseband signal or multiplying the target baseband signal by the target sideband suppression parameter. The compensation signal may be obtained by processing based on the target sideband suppression parameter.

In some embodiments, an initial compensation signal corresponding to the target baseband signal may be obtained; a target compensation signal may be obtained based on the target sideband suppression parameter and the initial compensation signal; and the target baseband signal may be corrected based on the target compensation signal to obtain a corrected target baseband signal.

Specifically, the initial compensation signal may be determined based on the target baseband signal. For example, the initial compensation signal may be a complex conjugated signal corresponding to the target baseband signal. A complex conjugated signal of a signal is a signal with the same real part and an opposite imaginary part. In a case that the target sideband suppression parameter is obtained, the target sideband suppression parameter may be used to process the initial compensation signal to obtain the target compensation signal. The target baseband signal is then corrected based on the target compensation signal to obtain the corrected target baseband signal.

In some embodiments, the obtaining the target compensation signal based on the target sideband suppression parameter and the initial compensation signal includes: multiplying the target sideband suppression parameter by the initial compensation signal to obtain a target compensation signal, the initial compensation signal being a complex conjugated signal corresponding to the target baseband signal, and a frequency of the initial compensation signal being opposite to a frequency of the target baseband signal. The correcting the target baseband signal based on the target compensation signal to obtain the corrected target baseband signal includes: adding the target compensation signal and the target baseband signal to obtain the corrected target baseband signal.

Specifically, because the frequency of the initial compensation signal is opposite to the frequency of the target baseband signal, the initial compensation signal is a complex conjugated signal corresponding to the target baseband signal. Therefore, the computer may perform a reverse processing on the target baseband signal, so that the corrected target baseband signal obtained by the correction offsets the useless sideband caused by the non-ideality of the modulator, that is, the useless sideband is suppressed. A general principle of sideband suppression is described as follows. The inventor of this application found that when the signal is modulated by a modulator, an error caused by the modulation is not fixed, but is related to the target signal related parameter corresponding to the baseband signal. Therefore, it is required to flexibly determine a signal compensation coefficient (that is, the sideband suppression parameter) based on the signal related parameter of the target baseband signal, and to flexibly determine the initial compensation signal based on the target baseband signal, so as to flexibly obtain the target compensation signal based on the target baseband signal, and add the target compensation signal and the target baseband signal to obtain the corrected target baseband signal. In this way, the useless sideband can be suppressed, and the baseband signal can be corrected in time based on the signal related parameter of the current baseband signal in a case that the baseband signal is constantly changing.

In some embodiments, it may be understood that in a case that the target compensation signal and the target baseband signal are added to obtain the corrected target baseband signal, if the target baseband signal is a signal in a time domain and the target compensation signal is a signal in a frequency domain, the target baseband signal in the time domain may be converted into a target baseband signal in the frequency domain, and then the target compensation signal and the target baseband signal in the frequency domain are added.

In some embodiments, when the target baseband signal obtained by the computer is a baseband signal in the time domain, that is, an analog signal, the correcting the target baseband signal based on the target compensation signal to obtain the corrected target baseband signal includes: performing frequency domain transformation on the target baseband signal in a time domain, to obtain a target baseband signal in a frequency domain; correcting the target baseband signal in the frequency domain based on the initial compensation signal, to obtain a corrected baseband signal in the frequency domain; and performing time domain transformation on the corrected baseband signal in the frequency domain, to obtain the corrected target baseband signal in the time domain.

Specifically, the frequency domain transformation refers to transforming a signal in the time domain into a signal in the frequency domain. The time domain transformation refers to transforming a signal in the frequency domain into a signal in the time domain. Fourier transform may be performed on the target baseband signal in the time domain to obtain the target baseband signal in the frequency domain, and obtain the frequency corresponding to the target baseband signal in the frequency domain. The initial compensation signal is a signal in the frequency domain. Therefore, the initial compensation signal in the frequency domain may be used to correct the target baseband signal in the frequency domain, to obtain the corrected baseband signal in the frequency domain. Inverse Fourier transform is then performed on the corrected baseband signal in the frequency domain to obtain the corrected target baseband signal in the time domain.

For example, for any target baseband signal $z_0(t)$, the computer may obtain the target baseband signal in the frequency domain through Fourier transform $\mathcal{F}$, which is represented by formula (1). The initial compensation signal may be the complex conjugated signal corresponding to the target baseband signal. Therefore, the target sideband suppression parameter is multiplied by the initial compensation signal, to obtain the target compensation signal, which may be represented by formula (2). The target compensation signal and the target baseband signal are added to obtain the corrected baseband signal in the frequency domain, which may be represented by formula (3). The time domain transformation is performed on the corrected baseband signal in the frequency domain, to obtain the corrected target baseband signal in the time domain, which may be represented by formula (4). $\hat{z}_0(f)$ represents the target baseband signal in the frequency domain with the frequency $f$, that is, a spectrum function. $i$ represents an imaginary number, $exp$ represents that a base number is a natural constant $e$, $Z_B$ represents the target compensation signal, and $-f$ represents an opposite frequency of the frequency f of the target baseband signal. $f_c$ represents the frequency of the carrier. $c$ represents the sideband suppression parameter. $\widehat{z_0}^{*}(-f)$ represents $\mathcal{F}[z_0(t)^{*}(-f)$, where "*" represents the complex conjugate. $|\widehat{z_0}(-f)|$ represents the amplitude of $\widehat{z_0}(-f)$. $\hat{z}(f)$ represents the corrected baseband signal in the frequency domain, and $z(t)$ represents the corrected target baseband signal in the time domain. It may be understood that the target signal related parameter may further include another parameter, for example, may include a signal length.

$$\mathcal{F}[z_0(t)] = \hat{z}_0(f) = \int_{-\infty}^{\infty} z_0(t) \exp\left[-2\pi i f t\right] dt \qquad (1)$$

$$Z_B = c(f_c, -f, |\widehat{z}_0(-f)|) \, \widehat{z}_0^*(-f) \qquad (2)$$

$$\widehat{z}(f) = \widehat{z}_0(f) + c(f_c, -f, |\widehat{z}_0(-f)|) \, \widehat{z}_0^*(-f) \qquad (3)$$

$$z(t) = \int_{-\infty}^{\infty} \widehat{z}(f) \, exp\left[2\pi i f t\right] df \qquad (4)$$

In step S210, the corrected target baseband signal is inputted to a modulator for signal modulation, to obtain a target modulation signal corresponding to the target baseband signal.

Specifically, after obtaining the corrected target baseband signal, the computer may use a real part of the corrected target baseband signal as an input to the port I of the modulator, use an imaginary part of the corrected target baseband signal as an input to the port Q of the modulator, and use the carrier signal as an input to the port LO of the modulator, to use the carrier for modulation to obtain the modulated signal as the target modulation signal, and the target modulation signal is outputted from the port RF of the modulator.

For example, it is assumed that the corrected target baseband signal is represented as $z(t)$, the real part $\Re[z(t)]$ of the corrected target baseband signal may be used as the input to the channel I, and the imaginary part $\Im[z(t)]$ of the corrected target baseband signal may be used as the input to the channel Q. That is, $I(t) = \Re[z(t)]$, $Q(t) = \Im[z(t)]$. Because correction processing may be pre-performed on the baseband signal, for the modulated signal, the signal on the suppression sideband is suppressed. Therefore, the outputted modulated signal contains only a desired output frequency component or contains few useless frequency components. Therefore, for any baseband signal, signal correction may be performed based on a signal related parameter thereof to suppress a sideband of any signal.

In the foregoing sideband suppression method, when the target baseband signal needs to be transmitted, the target sideband suppression parameter may be obtained based on the target signal related parameter corresponding to the target baseband signal. In a case that signal correction is performed on the target baseband signal based on the target sideband suppression parameter, the target baseband signal is inputted to the modulator for signal modulation, to obtain the target modulation signal corresponding to the target baseband signal. Before modulating the baseband signal, correction processing is performed on the baseband signal based on the target sideband suppression parameter, to suppress the power of the suppression sideband corresponding to the target baseband signal. Therefore, in a case that the corrected baseband signal is inputted to the modulator for signal modulation, the signal of the suppression sideband is suppressed, thereby improving the signal transmission efficiency and the signal fidelity.

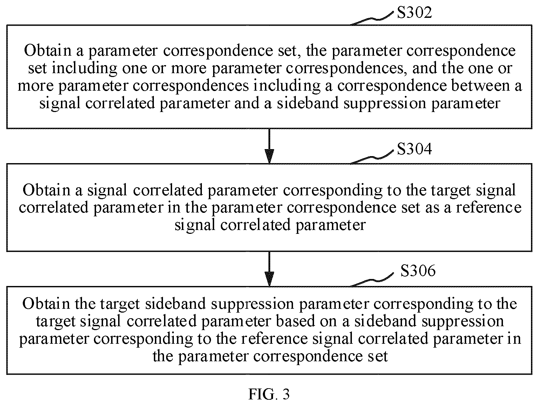

In some embodiments, as shown in FIG. 3, the obtaining a corresponding target sideband suppression parameter based on a target signal related parameter includes the following steps S302 to S306.

In step S302, a parameter correspondence set is obtained, the parameter correspondence set includes one or more parameter correspondences, and the one or more parameter correspondences include a correspondence between a signal related parameter and a sideband suppression parameter.

Specifically, the parameter correspondence set may include one or more parameter correspondences, the number of which may be set according to requirements. For example, the parameter correspondence set may include a sideband suppression parameter corresponding to a commonly used signal related parameter, which is determined according to actual requirements. Because different baseband signals may correspond to different sideband suppression parameters, and baseband signals and carrier signals used in different scenarios may be different, the correspondence between a signal related parameter and a sideband suppression parameter may be pre-determined. For example, the sideband suppression parameters corresponding to the carrier frequency, the baseband frequency, and baseband amplitude may be pre-stored, and when signal correction is to be performed, the corresponding sideband suppression parameter may be obtained based on the parameter correspondences.

In step S304, a signal related parameter corresponding to the target signal related parameter in the parameter correspondence set is obtained as a reference signal related parameter.

Specifically, the signal related parameter corresponding to the target signal related parameter may be a directly corresponding signal related parameter or an indirectly corresponding signal related parameter. In an example, the indirectly corresponding signal related parameter may indicate that a transformed signal related parameter is obtained by transforming the target signal related parameter, and a signal related parameter corresponding to the transformed signal related parameter is obtained as the reference signal related parameter. For example, it is assumed that the target sideband suppression parameter includes the frequency $f$ of the target baseband signal, the frequency $f$ is transformed to a frequency $-f$, and a signal related parameter directly or indirectly corresponding to the frequency $-f$ is obtained as the reference signal related parameter.

In some embodiments, if the initial compensation signal is the complex conjugated signal corresponding to the target baseband signal, the frequency of the initial compensation signal is opposite to the frequency $f$ of the target baseband signal, and is $-f$. The target sideband suppression parameter, that is, the compensation coefficient, is used to process the initial compensation signal. Because the target sideband suppression parameter is used to process the initial compensation signal, the sideband suppression parameter corresponding to the signal related parameter corresponding to the initial compensation signal is to be obtained. Therefore, the signal related parameter of the corresponding initial compensation signal may be obtained based on the target signal related parameter, and the reference signal related parameter may be obtained based on the signal related parameter of the initial compensation signal. For example, the frequency opposite to the frequency of the target baseband signal may be obtained, and an amplitude corresponding to the initial compensation signal at the opposite frequency $-f$ may be obtained. The frequency $-f$ opposite to the frequency of the target baseband signal, the amplitude corresponding to the initial compensation signal, and the frequency of the carrier signal are used as reference signal related parameters.

In a practical example, it is assumed that the frequency of the target baseband signal is $f$, if the signal related parameter of the parameter correspondence set includes the frequency $-f$, the frequency $-f$ may be obtained as the reference signal related parameter. If the signal related parameter of the parameter correspondence set does not include the frequency $-f$, a frequency close to the frequency $-f$ may be obtained as the reference signal related parameter.

In step S306, the target sideband suppression parameter corresponding to the target signal related parameter is obtained based on a sideband suppression parameter corresponding to the reference signal related parameter in the parameter correspondence set.

Specifically, the computer may use the sideband suppression parameter corresponding to the reference signal related parameter as the target sideband suppression parameter corresponding to the target signal related parameter. Alternatively, interpolation calculation may be performed based on the sideband suppression parameter corresponding to the reference signal related parameter in the parameter correspondence set, to obtain the target sideband suppression parameter corresponding to the target signal related parameter.

In a practical example, if the signal related parameter of the parameter correspondence set includes the frequency $-f$, the sideband suppression parameter corresponding to the frequency $-f$ may be obtained as the target sideband suppression parameter corresponding to the target signal related parameter. If the signal related parameter of the parameter correspondence set does not include the frequency $-f$, a frequency close to the frequency $-f$ may be obtained as a reference frequency, and a sideband suppression parameter of the reference frequency may be obtained for interpolation calculation, to obtain the target sideband suppression parameter corresponding to the target signal related parameter.

In this embodiment of this application, different signal related parameters, such as sideband compensation parameters corresponding to different carrier frequencies, different sideband frequencies, and different signal amplitudes, may be pre-calculated to obtain a multi-dimensional table of the sideband compensation parameter $c$. In practice, an actual coefficient may be obtained by looking up the table. In a case that the actual coefficient is obtained, signal processing may be performed according to formula (3), and time domain conversion may be performed according to formula (4), to obtain a high-precision corrected target baseband signal.

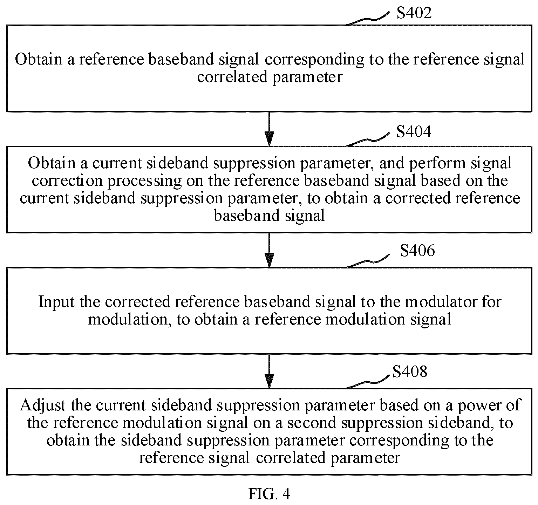

In some embodiments, in the parameter correspondence set, a sideband suppression parameter corresponding to each signal related parameter may be obtained through experiments. With reference to FIG. 4 below, the signal related parameter corresponding to the target signal related parameter in the parameter correspondence set, that is, the reference signal related parameter, is used as an example, to describe the steps of obtaining the sideband suppression parameter corresponding to the reference signal related parameter. It may be understood that a sideband suppression parameter corresponding to each signal related parameter in the parameter correspondence set may be obtained with the same algorithm. As shown in FIG. 4, steps of obtaining a sideband suppression parameter corresponding to a reference signal related parameter in a parameter correspondence set include the following steps S402 to S408.

In step S402, a reference baseband signal corresponding to the reference signal related parameter is obtained.

Specifically, the reference baseband signal corresponding to the reference signal related parameter means that the signal related parameter of the reference baseband signal may be the reference signal related parameter or the signal related parameter of the complex conjugated signal corresponding to the reference baseband signal. For example, in a case of a carrier frequency $f_c$, a baseband signal amplitude A, and a baseband frequency $f$, a reference baseband signal corresponding to the signal amplitude A and the frequency $f$ may be obtained, and a frequency of a carrier signal corresponding to the reference baseband signal is $f_c$.

In step S404, a current sideband suppression parameter is obtained, and signal correction is performed on the reference baseband signal based on the current sideband suppression parameter, to obtain a corrected reference baseband signal.

Specifically, the current sideband suppression parameter is a sideband suppression parameter currently used for correction. In the process of determining the sideband suppression parameter, multiple experiments may be carried out to determine an optimal value of the sideband suppression parameter. Therefore, the current sideband suppression parameter may change as the experiment progresses. The initial current sideband suppression parameter may be any value, for example, may be 0. The steps of performing signal correction on the reference baseband signal based on the current sideband suppression parameter, to obtain a corrected reference baseband signal may refer to the steps of performing signal correction on the target baseband signal based on the target sideband suppression parameter, to obtain a corrected target baseband signal. For example, the obtaining a current sideband suppression parameter, and performing signal correction on the reference baseband signal based on the current sideband suppression parameter, to obtain a corrected reference baseband signal may be performed according to a formula (5), where $Z_c(t)$ represents the corrected reference baseband signal, $A \exp(2\pi ift)$ represents the reference baseband signal before the correction, and *exp* represents that a base number is a natural constant *e*. $c_d$ represents the current sideband suppression parameter, and $A \exp(2\pi ift)$ represents the initial compensation signal corresponding to the reference baseband signal.

$$Z_{\mathrm{c}}(t) = I(t) + iQ(t) = A \exp\left(2\pi ift\right) + c_{\mathrm{d}} \cdot A \exp\left(-2\pi ift\right) \qquad (5)$$

In step S406, the corrected reference baseband signal is inputted to the modulator for modulation, to obtain a reference modulation signal.

Specifically, after the corrected reference baseband signal is obtained, the corrected reference baseband signal may be inputted to the modulator for modulation, and the modulated signal is used as the reference modulation signal.

In step S408, the current sideband suppression parameter is adjusted based on a power of the reference modulation signal on a corresponding second suppression sideband, to obtain the sideband suppression parameter corresponding to the reference signal related parameter.

Specifically, the second suppression sideband is a sideband that needs to be suppressed in the reference modulation signal. For example, if the reference baseband signal is at *f* and the carrier frequency is *f* the second sideband that needs to be suppressed may be at $f_c$+f. The power of the reference modulation signal on the corresponding second suppression sideband may be calculated, and the current sideband suppression parameter is adjusted with a purpose of decreasing the power of the reference modulation signal on the corresponding second suppression sideband, to obtain an updated current sideband suppression parameter. A gradient-free minimization algorithm, such as a Nelder-Mead (downhill simplex) algorithm or a Powell (Powell optimization, also referred to as directional acceleration) algorithm, may be used, to adjust the current sideband suppression parameter with a purpose of decreasing the power of the reference modulation signal on the corresponding second suppression sideband, to obtain an updated current sideband suppression parameter.

In some embodiments, steps S404 to S408 may be executed for multiple times. If an update stop condition is not met, step S404 may be performed based on the updated current sideband suppression parameter, and the current sideband suppression parameter is updated repeatedly according to steps S404 to S408, until the update stop condition is met, then the finally updated current sideband suppression parameter is used as the sideband suppression parameter corresponding to the reference signal related parameter. The update stop condition includes at least one of the following: a change of the updated current sideband suppression parameter relative to the current sideband suppression parameter before the updating is less than a preset change threshold, the power on the second suppression sideband is less than a preset power threshold, and the number of time for updating the current sideband suppression parameter is greater than a preset number. The preset change threshold, the preset number, and the preset power threshold may be set according to requirements. For example, the preset change threshold may be 0.01, and the preset number may be 100 times.

In some embodiments, the target signal related parameter includes: a baseband frequency corresponding to the target baseband signal, a baseband amplitude corresponding to the target baseband signal, and a carrier frequency of the carrier signal corresponding to the target baseband signal. The obtaining a corresponding target sideband suppression parameter based on a target signal related parameter includes: obtaining the carrier frequency; obtaining a parameter correspondence set corresponding to the carrier frequency, the parameter correspondences including a correspondence between a baseband frequency corresponding to a baseband signal and a sideband suppression parameter, and a correspondence between a baseband amplitude corresponding to the baseband signal and the sideband suppression parameter; and obtaining the target sideband suppression parameter from the parameter correspondence set based on the baseband frequency corresponding to the target baseband signal and the baseband amplitude corresponding to the target baseband signal.

Specifically, the baseband frequency corresponding to the baseband signal is the frequency of the baseband signal. In a quantum computer, a modulation signal used to modulate a superconducting qubit may be continuous, and the carrier frequency may be fixed. For each target baseband signal in the modulation signal, a carrier frequency of the modulation signal may be used for modulation. One of the target baseband signals may be a baseband signal of a preset time length in the modulation signal. Therefore, a parameter correspondence set corresponding to the carrier frequency corresponding to the modulation signal that modulates the superconducting qubit may be obtained. In this way, a correspondence between a baseband frequency corresponding to a baseband signal and a sideband suppression parameter, and a correspondence between a baseband amplitude corresponding to the baseband signal and the sideband suppression parameter may be searched from the parameter correspondence set, to improve the speed of obtaining the target sideband suppression parameter.

In some embodiments, the corrected target baseband signal obtained by correction may include a real part and an imaginary part. Therefore, the real part corresponding to the corrected target baseband signal may be inputted to an in-phase end (the port I) of the modulator, the imaginary part corresponding to the corrected target baseband signal is inputted to an orthogonal end (the port Q) of the modulator, and signal modulation is performed by using the carrier signal of the carrier frequency to obtain the target modulation signal corresponding to the target baseband signal. In this way, the target modulation signal may be used to modulate the superconducting qubit, to control the quantum computer.

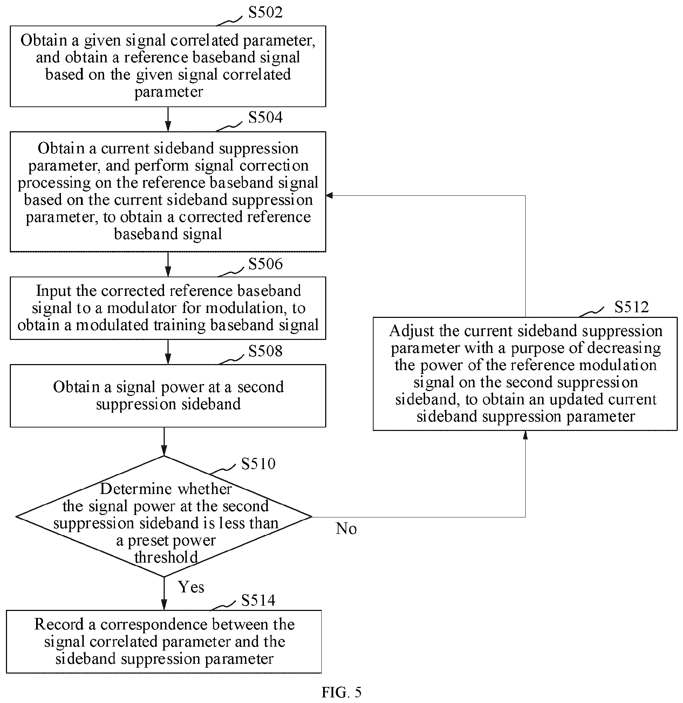

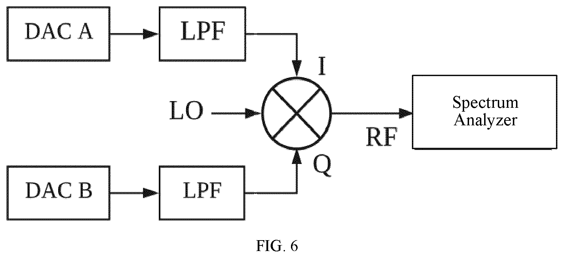

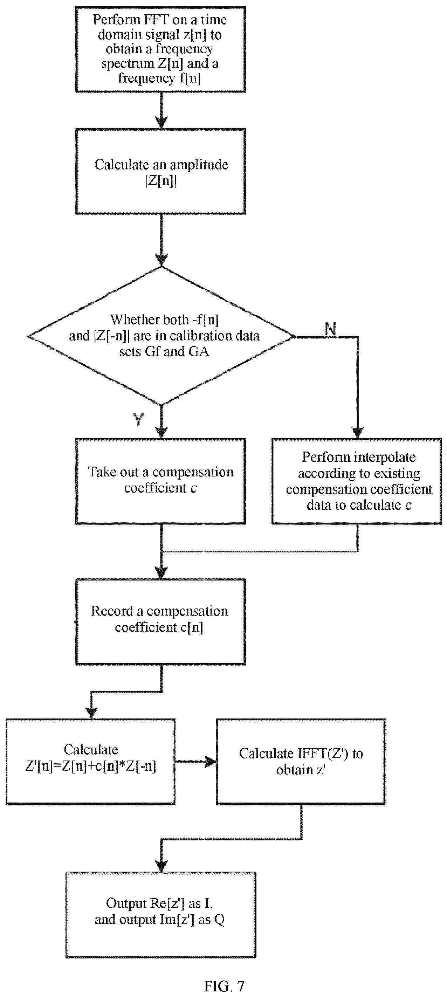

An example is used below in which the superconducting qubit is modulated. The solution of this embodiment of this application is described with reference to FIG. 5 to FIG. 7, where FIG. 5 is a flowchart of a process for sideband calibration. FIG. 6 is a diagram of a connection relationship between devices during sideband calibration. FIG. 7 is a schematic diagram of a specific embodiment of implementing signal sideband suppression. The sideband calibration refers to a process of obtaining a sideband suppression parameter required to implement sideband suppression for the actual IQ modulator, and the sideband calibration may be pre-performed. The sideband suppression refers to suppression of power of a mirror sideband. A mirror sideband refers to another sideband symmetrical to a carrier and generated due to the non-ideality of a device in single-sideband modulation.

As shown in FIG. 5, the sideband calibration includes the following steps S502 to S514.

In step S502, a given signal related parameter is obtained, and a reference baseband signal is obtained based on the given signal related parameter.

Specifically, in a case of a carrier frequency $f_c$, a baseband signal amplitude A and a baseband frequency $f$, the reference baseband signal $A \exp(2\pi i f t)$ may be obtained.

In step S504, a current sideband suppression parameter is obtained, and signal correction is performed on the reference baseband signal based on the current sideband suppression parameter, to obtain a corrected reference baseband signal.

Specifically, an initial current sideband suppression parameter, that is, a compensation coefficient $c$, may be 0. $c$ may be updated subsequently. A calculation formula for the corrected reference baseband signal $Z_c(t)$ may be expressed as $Z_C(t) = I(t) + iQ(t) = A \exp(2\pi i f t) + c_d \cdot A \exp(-2\pi i f t)$.

In step S506, the corrected reference baseband signal is inputted to a modulator for modulation, to obtain a modulated training baseband signal.

Specifically, the corrected reference baseband signal $Z_c(t)$ is obtained and then inputted to the modulator, where a real part $\Re[Z_C(t)]$ is inputted to a port I, and an imaginary part $\Im[Z_C(t)]$ is inputted to a port Q.

In step S508, a signal power at a second suppression sideband is obtained.

In step S510, it is determined whether the signal power at the second suppression sideband is less than a preset power threshold.

If the signal power at the second suppression sideband is less than a preset power threshold, step 514 is performed; and if the signal power at the second suppression sideband is not less than a preset power threshold, step 512 is performed.

In step S512, the current sideband suppression parameter is adjusted with a purpose of decreasing the power of the reference modulation signal on the corresponding second suppression sideband, to obtain an updated current sideband suppression parameter.

In step S514, a correspondence between the signal related parameter and the sideband suppression parameter is recorded.

Specifically, $f_c + f$ corresponds to a useless sideband. A spectrum analyzer may be used to measure a signal outputted from a port RF and measure a signal power $P(c, f_c, f, A)$ at a frequency $f_c + f$. A gradient-free minimization algorithm, such as the Nelder-Mead algorithm or the Powell algorithm, is used to optimize $c$ in the power $P(c, f_c, f, A)$. That is, the sideband suppression parameter $c$ is changed with a purpose of decreasing the power. Finally, the sideband suppression parameter c corresponding to the given signal related parameter is obtained. It may be understood that because frequencies and amplitudes of the baseband signal in different scenarios may be different, to flexibly select the sideband suppression parameter based on the signal related parameter of the baseband signal, the given signal related parameter may be changed. For example, the baseband signal amplitude A, the frequency $f$, and the carrier frequency $f_c$ are changed, the process of S502 to S512 is repeated, to obtain a value $c(f_c, f, A)$ of the compensation coefficient c under a different carrier frequency $f_c$, a different baseband frequency $f$, and a different baseband signal amplitude A, and a correspondence between a signal related parameter and a sideband suppression parameter is recorded, for example, $f_c$, $f$, A, c. In this way, a multi-dimensional table of the sideband suppression parameter c may be obtained. In practice, an actual sideband suppression coefficient may be obtained by looking up the table.

As shown in FIG. 6, after passing through DAC A, the real part of the corrected reference baseband signal passes through a low-pass filter and then is connected to the port I of the IQ modulator, and after passing through DAC B, the imaginary part of the corrected reference baseband signal passes through a low-pass filter and then is connected to the port Q of the IQ modulator. A sine wave of a frequency $f_c$ is connected to the port LO of the IQ modulator, and a power thereof meets normal working requirements of the IQ modulator. In addition, the RF port is connected to the spectrum analyzer to measure an outputted RF signal to obtain a power at a frequency $f_{c+}$ $f$.

After obtaining a sideband suppression parameter corresponding to each signal related parameter, a multi-dimensional table used for searching the sideband suppression parameter $c$ may be obtained. The table includes the correspondence between a signal related parameter and a sideband suppression parameter. During signal transmission, an actual sideband suppression coefficient may be obtained by looking up the table. The following describes how to perform sideband suppression with reference to FIG. 7, which includes the following steps 1 to 6.

In step 1, the parameter correspondence set corresponding to the carrier frequency is obtained.

For example, as shown in FIG. 7, if the current carrier frequency is $f_c$, the compensation coefficient $c$ corresponding to $f_c$, the corresponding baseband frequency $f$, and the baseband amplitude A are taken out and sent to the FPGA for temporary storage. The corresponding baseband frequency $f$ is a set $G_f$, the corresponding baseband amplitude A is a set $G_A$, the compensation coefficient $c[f_m, A_n]$ is a two-dimensional array, $f_m$ represents a frequency of an $m^{th}$ calibrated baseband signal, and n represents a baseband amplitude of an $n^{th}$ calibrated baseband signal.

In step 2, frequency domain transformation is performed on the target baseband signal in a time domain, to obtain a target baseband signal in a frequency domain.

For example, as shown in FIG. 7, in a case that the FPGA receives time domain data z[n]=I[n]+iQ[n] of the inputted baseband signal, fast Fourier transform (FFT) is performed to obtain a spectrum $\hat{z}[n]$ of the baseband signal and the corresponding frequency f[n].

In step 3, the target signal related parameter corresponding to the target baseband signal is obtained.

For example, as shown in FIG. 7, the amplitude $\hat{z}[n]|$ may be calculated based on spectrum data $\hat{z}[n]$. At a frequency point $-f[n]$ and the amplitude $|\hat{z}[-n]|$, the sideband suppression parameter, that is, the compensation coefficient $c$ is obtained based on the parameter correspondence set, where $\hat{z}[n]$ corresponds to the frequency $f[n]$, and $\hat{z}[-n]$ corresponds to the frequency $-f[n]$. Herein, there may be the following three cases. "Y" in FIG. 7 represents "Yes", and "N" represents "No". In FIG. 7, taking out the compensation coefficient c corresponds to a case 1, and performing interpolation based on the existing compensation coefficient data corresponds to cases 2 and 3.

In the case 1, if the frequency point $-f[n]$ and the amplitude $|\hat{z}[-n]|$ are both included in the stored parameter correspondence set (a calibration data set), the compensation coefficient $c$ corresponding to $-f[n]$ and $|\hat{z}[-n]|$ is directly taken out from the stored parameter correspondence set.

In a case 2, if only one of the frequency point $-f[n]$ and amplitude $|\hat{z}[-n]|$ is included in the stored parameter correspondence set, a parameter that does not exist in the parameter correspondence set is used as an independent variable, the compensation coefficient $c$ is used as a dependent variable, and interpolation calculation is performed based on the parameter correspondence set, to calculate the corresponding compensation coefficient $c$ at the frequency point $-f[n]$ and amplitude$|\hat{z}[-n]|$.

In a case 3, if none of the frequency point $-f[n]$ and the amplitude $|\hat{z}[-n]|$ is included in the parameter correspondence set, the two parameters are used as a first independent variable and a second independent variable, the compensation coefficient c is used as a dependent variable, and interpolation calculation is performed based on the parameter correspondence set, to calculate the corresponding compensation coefficient $c$ at the frequency point $-f[n]$ and amplitude $|\hat{z}[-n]|$.

In step 4, signal correction is performed on the target baseband signal based on the target sideband suppression parameter to obtain the corrected target baseband signal.

Specifically, as shown in FIG. 7, the corrected baseband signal $\widehat{z'}[n]$ in the frequency domain may be calculated according to the formula $\widehat{z'}[n] = \hat{z}[n] + c[n] \times \hat{z}^*[-n]$, and inverse Fourier transform (IFFT) is performed on $\widehat{z'}[n]$, to obtain the data z'[n] in the time domain.

In step 5, the corrected target baseband signal is inputted to a modulator for signal modulation, to obtain a target modulation signal corresponding to the target baseband signal.

As shown in FIG. 7, the real part $\Re[z'[n]]$ (that is, Re[z']) of the corrected target baseband signal may be sent to the DAC connected to the channel I of the IQ modulator, and the imaginary part $\Im[z'[n]]$ (that is, Im[z']) of the corrected target baseband signal may be sent to the DAC connected to the channel Q of the IQ modulator, to obtain the target modulation signal by the modulator.

In step 6, the superconducting qubit is modulated based on the target modulation signal.

The solutions provided in this embodiment of this application may adopt a solution in which correction is performed in the frequency domain, and the correction may be performed at multiple frequencies and multiple amplitudes. By correcting a signal, a high-quality control signal may be obtained. Therefore, the solution of this embodiment of this application may be applied to a superconducting quantum computer and measurement and control components of the superconducting quantum computer, including arbitrary waveform generators and digital-to-analog conversion modules. The solution of this embodiment of this application may also be applied to correct any signal with a large bandwidth, to reduce the waveform distortion, meeting measurement and control accuracy requirements of superconducting quantum computing. The principles and effects of the method provided in this embodiment of this application is described below.

The IQ modulator may modulate a low-frequency signal to be at a radio frequency band, and is widely used in the modulation and reading of superconducting qubits in the field of superconducting quantum computing. In an application of a superconducting qubit, a microwave signal usually needs to have a frequency near the energy level difference between the two energy levels $|0\rangle$, $|1\rangle$ of the superconducting qubit, and the typical value corresponding to the frequency is around 6 GHz. The carrier frequency used is generally located in a range of several hundred MHz centered on the frequency of the qubit. An operation principle of an ideal IQ modulator may be described by using the following formula (6):

$$s(t) = \beta[I(t) \cos 2\pi f_c t + Q(t) \sin 2\pi f_c t] \#(6)$$

where $s(t)$ represents a modulation signal outputted from the port RF of the IQ modulator, $I(t)$, $Q(t)$ represent medium frequency signals inputted from the port I and the port Q of the IQ modulator, the frequency of the carrier signal in the part LO is $f_c$, $\beta$ is used to describe conversion loss of the IQ modulator. When $I(t) + iQ(t) = A(t) e^{j2\pi ft}$, the signal $s(t) = \beta A(t) \cos 2\pi (f_c - f)t$ is outputted, thereby modulating the signal amplitude and changing the carrier frequency.

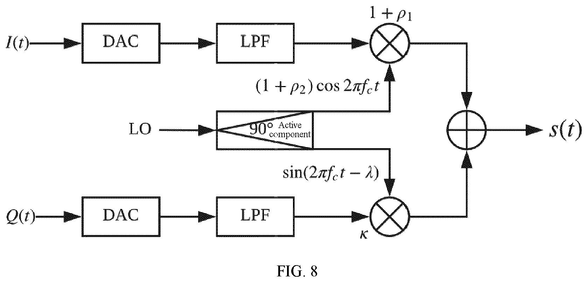

However, the actual IQ modulator is non-ideal, and there are mainly four kinds of errors: IQ baseband amplitude imbalance $\rho_1$, IQ baseband phase imbalance $\kappa$, quadrature carrier amplitude imbalance $\rho_2$, and quadrature carrier phase imbalance $\lambda$. When the errors are taken into account, the modulation signal may be described by using a mathematical form of formula (7) to describe [6], and an operation principle of a quadrature modulator containing errors is as shown in FIG. 8, where $1 + \rho = (1 + \rho_1)(1 + \rho_2)$, which represents final amplitude imbalance between the two channels of IQ.

$$s(t) = \beta\{(1 + \rho) \cos 2\pi ft \cos 2\pi f_c t + \sin (2\pi ft - \kappa) \sin (2\pi f_c t - \lambda)\}$$
$$= \frac{\beta}{2}\{(1 + \rho) \cos (2\pi ft - 2\pi f_c t) + (1 + \rho) \cos (2\pi ft + 2\pi f_c t)$$
$$+ \sin (2\pi ft - 2\pi f_c t - \kappa + \lambda) - \sin (2\pi ft + 2\pi f_c t - \kappa - \lambda)\} \#(7)$$

It may be seen from formula (7) that in addition to a desired frequency component of $f_c - f$, the finally outputted radio frequency signal $s(t)$ also contains a frequency component of $f_c + f$ which reduces the quality of the signal and affects the fidelity of the operation of the superconducting qubit gate. Therefore, it is needed to correct the signal. For example, in an application of superconducting quantum computing, a signal generated by the IQ modulator is usually not a sine wave, but a Gaussian wave packet. A center frequency of the Gaussian wave packet is about 6 GHz, and a frequency spread is close to 100 MHz. In this case, because both a control signal and a read signal of the superconducting quantum computer are generated by the IQ modulator, obtaining a high-quality control signal is crucial for improving the accuracy of the quantum gate operation. If correction is not performed, large waveform distortion is caused and the fidelity of a quantum operation is affected.

Therefore, in the presence of errors, for any signal $z(t) = A(t)e^{i\phi(t)}$, a real part $I_0(t) = \Re[A(t)e^{i\phi(t)}]$ and an imaginary part $Q_0(t) = \Im[A(t)e^{i\phi(t)}]$ are IQ signals need to be modulated under ideal conditions. Z(t) may be expanded with Fourier series:

$$z(t) = \sum_{n=-\infty}^{+\infty} A_n e^{2\pi i f_n t + i\phi_n}$$

where $A_n$, $\phi_n$, $f_n$ are real numbers that meet $A_n e^{i\phi_n} = \frac{1}{T} \int_T z(t)e^{i2\pi f_n t} dt$, $f_n = \frac{n}{T}$, and $T$ represents a total duration of the signal $Z(t)$. Therefore, according to formula (7), the signal $s(t)$ outputted from the RF port of the IQ modulator may be represented as:

$$s(t) = \sum_{n=-\infty}^{+\infty} \beta A_n (1 + \rho) \cos (2\pi f_n t + \phi_n) \cos (2\pi f_c t) + \beta A_n \sin (2\pi f_n t + \phi_n - \kappa) \sin (2\pi f_c t - \lambda) \ \#(8)$$

It may be seen from formula (8) that if values of error sources $\rho$, $\kappa$, and $\lambda$ are related to the frequency $f_n$ or the amplitude $A_n$, the entire baseband signal waveform cannot be corrected simply by using the same calibration parameter. Therefore, for the sine wave signal $z_0(t) = I_0(t) + iQ_0(t) = A \exp[2\pi ift]$, to suppress a mirror sideband signal, that is, the signal of the frequency $f_c + f$, an equation $z(t) = z_0(t) + c \cdot z_0^*(t)$ is defined for the input end of IQ, where $c$ is an undetermined complex number, which needs to be measured in the actual process. The outputted signal $s(t)$ is defined as:

$$s(t) = [(1 + \rho)(\cos 2\pi ft + \Re[c] \cos 2\pi ft + \Im[c] \sin 2\pi ft) \cos 2\pi f_c t$$

$$+ [\sin (2\pi ft - \kappa) - \Re[c] \sin (2\pi ft + \kappa) + \Im[c] \cos (2\pi ft - \kappa)] \sin (2\pi f_c t - \lambda) \#(9)$$

The $f_c + f$ component of $s(t)$ is calculated, and the real part and the imaginary part of the compensation coefficient c are adjusted, so that the component of $f_c + f$ may be 0. Therefore, formula (10) may be obtained according to the formula (9).

$$c = \frac{-\rho(2 + \rho) + 2i \cos \kappa (\sin \kappa + (1 + \rho) \sin \lambda)}{\cos 2\kappa + (1 + \rho)(1 + \rho + 2 \cos \kappa \cos \lambda)} \#(10)$$

It may be seen from formula (10) that the compensation coefficient $c$ includes three error sources of the IQ modulator. Therefore, it may be seen from the foregoing analysis that by changing the input signal $z_0(t)$ at the port IQ to $z(t)$, a signal without a frequency component of the mirror sideband may be obtained.

Secondly, for any general signal $z_0(t)$, due to the actual IQ modulator itself, the IQ baseband amplitude imbalance $\rho$ and the baseband phase imbalance $\kappa$ thereof are usually related to the baseband frequency $f$ and the baseband signal amplitude $A$ at the current baseband frequency, and the carrier phase imbalance $\lambda$ is usually related to the carrier frequency $f_c$. Therefore, the compensation coefficient $c$ is related to the three factors of the carrier frequency $f_c$, the baseband frequency $f$, and the baseband amplitude $A$, so that the compensation coefficient $c$ may be represented as a function $c = c(f_c, f, A)$ of these variables. Like a sine wave signal, for any signal $z_0(t)$, Fourier transform

$\mathcal{F}[z_0(t)] = \hat{z}_0(f) = \int_{-\infty}^{\infty} z_0(t) \exp[-2\pi ift] \, dt$ is first performed to convert the signal $z_0(t)$ into

a frequency domain, to obtain a spectrum $\hat{z}_0(f)$ thereof, and the following corrections are performed thereon:

$$\hat{z}(f) = \hat{z}_0(f) + c(f_c, -f, |\hat{z}_0(-f)|) \hat{z}_0^*(-f) \#(11)$$

where $\hat{z}_0^*(-f)$ represents $\mathcal{F}[z_0(t)]^*(-f)$. In a case that the spectrum $\hat{z}_0(f)$ is obtained, $\hat{z}(f)$ is converted back to $z(t)$ in the time domain through inverse Fourier transform:

$$z(t) = \int_{-\infty}^{\infty} \hat{z}(f) \exp[2\pi ift] dt$$

where the real part $\Re[z(t)]$ is outputted from the channel I, and the imaginary part $\Im[z(t)]$ is outputted from the channel Q, that is, $I(t) = \Re[z(t)]$, $Q(t) = \Im[z(t)]$. According to the principle given above, it may be seen that the sideband suppression process is implemented on the useless sideband of the baseband signal. Therefore, undesired sideband signals are suppressed from the finally outputted signal, thereby suppressing a sideband of any signal.

The baseband signal is corrected in the frequency domain and then converted back to the time domain for output, so that calibration may be performed separately under different carrier frequencies, different sideband frequencies, and different signal amplitudes, to obtain a multi-dimensional table of the compensation coefficient $c$. In practice, an actual coefficient may be obtained by looking up the table. After obtaining the actual coefficient, correction is performed according to formula (11), to obtain a high-precision signal in the time domain.

**EP 3 920 426 B1**

According to the solution provided in this embodiment of this application, the waveform of the IQ modulator can be corrected under the condition of large bandwidth and varying baseband power, to achieve the effect of suppressing the mirror sideband, and improve the fidelity of the signal. In superconducting quantum computing, the fidelity of a superconducting qubit operation can be improved. A modulator IQ-0307 of Marki Company is used for a simulation test, where effects of the solution in this embodiment of this application with the solution without correction of the baseband signal and another correction solution are compared in the following three cases. The another correction solution refers to a solution of directly measuring the amplitude imbalance and the phase imbalance of the IQ modulator, and obtaining the corresponding error parameters $\rho$ and $\kappa+\lambda$, to correct the signal. In IQ-0307, a typical value of IQ amplitude error is 0.3 dB, which corresponds to $\rho \in [-0.04, 0.04]$. A typical value of IQ phase error is 3 degrees, and a corresponding radian is 0.05, that is, $\kappa, \lambda \in [-0.05, 0.05]$. In the following simulation, the carrier frequency is fixed at 5 GHz, an error model of an IQ mixer operates according to the formula (3), and $\beta =1$, $\rho, \kappa, \lambda$ are randomly generated within a frequency range of -0.5 GHz to 0.5 GHz, and a range thereof is specified as $\rho \in [-0.04, 0.04]$, $\kappa, \lambda \in [-0.05, 0.05]$.

In a test 1, in a case that the baseband signal is a sine wave, a length of the sine wave is 1024 ns, and the frequency is 125 MHz, the sideband image suppression caused without correction is about 25 dB, which is closer to the 23 dB provided by the actual device. By performing correction with the solution provided in this application, the sideband image suppression reaches about 60 dB, which is increased by about 35 dB.

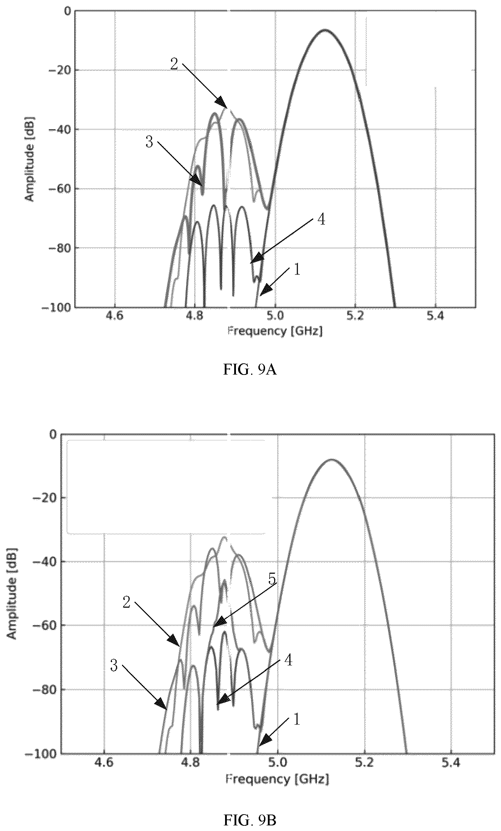

In a test 2, in a case that the error of the IQ modulator is not related to the baseband power, a Gaussian waveform is selected as the baseband signal, and a typical value of 10 ns in superconducting quantum computing is selected as a full width at half maximum of the Gaussian waveform. In addition, to obtain better frequency resolution, a total time is set as 1024 ns, and the baseband frequency is set as 125 MHz. FIG. 9A shows a comparison between other correction solutions and the special case (in the case that the errors $\rho, \kappa, \lambda$ are only related to the frequency, and are not related to the power) of this correction solution when the baseband signal is a Gaussian waveform. Line 1 represents a signal spectrum obtained by an ideal IQ mixer; line 2 represents spectrum data of a signal obtained by a non-ideal IQ modulator without correction; line 3 represents a signal spectrum obtained by the non-ideal IQ mixer in other correction solutions; and line 4 represents a signal spectrum obtained by the non-ideal IQ mixer under the correction solution of this embodiment of this application. It may be seen from FIG. 9A that for a wide-bandwidth Gaussian signal, with other correction solutions, correction can only be performed in a small frequency range near a fixed frequency, which is 125 MHz herein, while overall correction is not ideal, and sideband image suppression is not significantly improved. However, with the solution of this embodiment of this application, the sideband mirror suppression is improved by about 30 dB, reaching about 60 dB in the case of a sine wave.

In a test 3, FIG. 9B shows a comparison between other correction solutions and the solution of this embodiment of this application in a case that the errors of the IQ modulator (the baseband amplitude imbalance, the baseband phase imbalance, and the carrier phase imbalance) vary with the baseband power. Line 1 represents a signal spectrum obtained by an ideal IQ mixer; line 2 represents a signal spectrum obtained by a non-ideal IQ modulator without correction; line 3 represents a result obtained with another correction solution; line 4 represents a spectrum of a signal obtained by the non-ideal IQ modulator when the errors of the IQ modulator are related to both the baseband power and the baseband frequency in the solution of this application; and line 5 represents a correction result obtained when the errors of the IQ modulator are only related to the baseband frequency in the solution of this application. The baseband waveform used herein is still a Gaussian waveform, and a parameter of the Gaussian waveform is the same as that in test 2. It may be seen from FIG. 9B that when the errors of the IQ modulator change with the baseband power and the frequency, other correction solutions only have a certain suppression effect on the mirror signal in a small range near the center frequency. For the solution when the errors change with the baseband frequency (line 5), although the image signal may be suppressed in a wider range, the capability to suppress the signal near the center frequency is not strong enough. This is because the signal power is relatively strong near the center frequency, so that the errors ($\rho, \lambda, \kappa$) are quite different from the case in which the signal power is low. For the part far away from the center frequency, because the signal power itself is relatively low, the errors $\rho, \lambda$, and $\kappa$ are not much different. With the solution (line 4) that both the baseband frequency and the baseband power are considered, as may be seen from FIG. 9B, an image suppression effect thereof is significant. Compared with the existing solution, the sideband mirror suppression is improved by about 30 dB, and compared with the solution considering only the baseband frequency, the mirror suppression effect is improved by nearly 15 dB.

Therefore, it can be determined according to the foregoing tests that, according to the solution of this application, in a case that the baseband signals of large bandwidth and different powers are corrected, the signal of the mirror sideband, that is, the useless sideband, can be suppressed, where *frequency* represents the frequency and *amplitude* represents the amplitude.

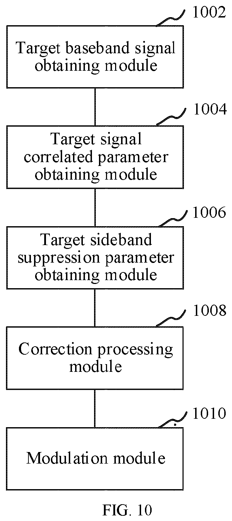

As shown in FIG. 10, in some embodiments, a sideband suppression apparatus is provided. The sideband suppression apparatus may be integrated in the foregoing FPGA, and may include a target baseband signal obtaining module 1002, a target signal related parameter obtaining module 1004, a target sideband suppression parameter obtaining module 1006, a correction processing module 1008, and a modulation module 1010. The target baseband signal obtaining module 1002 is configured to obtain a target baseband signal. The target signal related parameter obtaining module 1004 is configured to obtain a target signal related parameter corresponding to the target baseband signal, the target signal related parameter including at least one of a signal characteristic parameter corresponding to the target baseband signal or a signal characteristic parameter of a carrier signal corresponding to the target baseband signal. The target sideband suppression parameter obtaining module 1006 is configured to obtain a target sideband suppression parameter based on the target signal related parameter. The correction processing module 1008 is configured to perform signal correction on the target baseband signal based on the target sideband suppression parameter, to obtain a corrected target baseband signal, the target sideband suppression parameter is used for suppressing a power of a first suppression sideband corresponding to the target baseband signal. The modulation module 1010 is configured to input the corrected target baseband signal to a modulator for signal modulation, to obtain a target modulation signal corresponding to the target baseband signal.

In some embodiments, the correction processing module 1008 includes an initial compensation signal obtaining unit, a target compensation signal obtaining unit, and a correction unit. The initial compensation signal obtaining unit is configured to obtain an initial compensation signal corresponding to the target baseband signal. The target compensation signal obtaining unit is configured to obtain a target compensation signal based on the target sideband suppression parameter and the initial compensation signal. The correction unit is configured to correct the target baseband signal based on the target compensation signal to obtain a corrected target baseband signal.

In some embodiments, the target compensation signal obtaining unit is configured to multiply the target sideband suppression parameter by the initial compensation signal to obtain a target compensation signal, the initial compensation signal is a complex conjugated signal corresponding to the target baseband signal, and a frequency of the initial compensation signal is opposite to a frequency of the target baseband signal. The correction unit is configured to add the target compensation signal and the target baseband signal to obtain the corrected target baseband signal.

In some embodiments, the correction unit is configured to perform frequency domain transformation on the target baseband signal in a time domain, to obtain a target baseband signal in a frequency domain; correct the target baseband signal in the frequency domain based on the initial compensation signal, to obtain a corrected baseband signal in the frequency domain; and perform time domain transformation on the corrected baseband signal in the frequency domain, to obtain the corrected target baseband signal in the time domain.

In some embodiments, the target sideband suppression parameter obtaining module 1006 includes a parameter correspondence set obtaining unit, a reference signal related parameter obtaining unit, and a target sideband suppression parameter obtaining unit. The parameter correspondence set obtaining unit is configured to obtain a parameter correspondence set, the parameter correspondence set includes one or more parameter correspondences, and the one or more parameter correspondences include a correspondence between a signal related parameter and a sideband suppression parameter. The reference signal related parameter obtaining unit is configured to obtain a signal related parameter corresponding to the target signal related parameter in the parameter correspondence set as a reference signal related parameter. The target sideband suppression parameter obtaining unit is configured to obtain a target sideband suppression parameter corresponding to the target signal related parameter based on a sideband suppression parameter corresponding to the reference signal related parameter in the parameter correspondence set.

In some embodiments, the target sideband suppression parameter obtaining unit is configured to perform interpolation calculation based on the sideband suppression parameter corresponding to the reference signal related parameter in the parameter correspondence set, to obtain the target sideband suppression parameter corresponding to the target signal related parameter.

In some embodiments, the target sideband suppression parameter obtaining module is configured to obtain the sideband suppression parameter corresponding to the reference signal related parameter in the parameter correspondence set by: obtaining a reference baseband signal corresponding to the reference signal related parameter; obtain a current sideband suppression parameter, and perform signal correction on the reference baseband signal based on the current sideband suppression parameter, to obtain a corrected reference baseband signal; input the corrected reference baseband signal to the modulator for modulation, to obtain a reference modulation signal; and adjust the current sideband suppression parameter based on a power of the reference modulation signal on a corresponding second suppression sideband, to obtain the sideband suppression parameter corresponding to the reference signal related parameter.

In some embodiments, the target sideband suppression parameter obtaining module is configured to: adjust the current sideband suppression parameter with a purpose of decreasing the power of the reference modulation signal on the corresponding second suppression sideband, to obtain an updated current sideband suppression parameter; and repeating the step of obtaining a current sideband suppression parameter, and performing signal correction on the reference baseband signal based on the current sideband suppression parameter, to obtain a corrected reference baseband signal, until an update stop condition is met, and take the updated current sideband suppression parameter as the sideband suppression parameter corresponding to the reference signal related parameter. The update stop condition includes at least one of the following: a change of the updated current sideband suppression parameter relative to the current sideband suppression parameter before updating is less than a preset change threshold, the power on the second suppression sideband being less than a preset power threshold, or the number of times for updating the current sideband suppression parameter being greater than a preset number.

In some embodiments, the target signal related parameter includes a baseband frequency corresponding to the target baseband signal, a baseband amplitude corresponding to the target baseband signal, and a carrier frequency of the carrier signal corresponding to the target baseband signal, and the target sideband suppression parameter obtaining module 1006 is configured to: obtain the carrier frequency; obtain a parameter correspondence set corresponding to the carrier frequency, the parameter correspondences including a correspondence between a baseband frequency corresponding to a baseband signal and a sideband suppression parameter, and a correspondence between a baseband amplitude corresponding to the baseband signal and the sideband suppression parameter; and obtain the corresponding target sideband suppression parameter from the parameter correspondence set based on the baseband frequency corresponding to the target baseband signal and the baseband amplitude corresponding to the target baseband signal.

In some embodiments, the modulation module 1010 is configured to input a real part corresponding to the corrected target baseband signal to an in-phase end of the modulator, input an imaginary part corresponding to the corrected target baseband signal to an orthogonal end of the modulator, and perform signal modulation by using the carrier signal of the carrier frequency to obtain the target modulation signal corresponding to the target baseband signal, to modulate a superconducting qubit based on the target modulation signal.

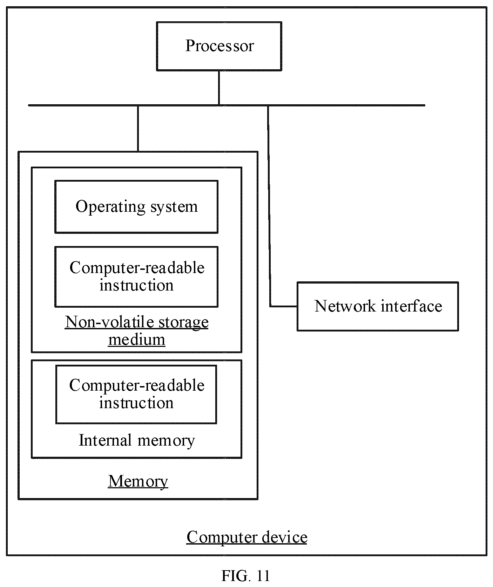

FIG. 11 is a diagram of an internal structure of a computer device according to some embodiments. The computer device may be specifically the FPGA in FIG. 1. As shown in FIG. 11, the computer device includes a processor, a memory, and a network interface that are connected through a system bus. The memory includes a non-volatile storage medium and an internal memory. The non-volatile storage medium of the computer device stores an operating system, and may further store computer-readable instructions. The computer-readable instructions, when executed by the processor, may cause the processor to implement a sideband suppression method. The internal memory may also store a computer-readable instruction, and when the computer-readable instruction is executed by the processor, the processor may be caused to perform the sideband suppression method.

A person skilled in the art may understand that, the structure shown in FIG. 11 is only a block diagram of a part of a structure related to a solution of this application and does not limit the computer device to which the solution of this application is applied. Specifically, the computer device may include more or fewer members than those in the drawings, or include a combination of some members, or include different member layouts.

In some embodiments, the sideband suppression apparatus provided in this application may be implemented in a form of computer-readable instructions, and the computer-readable instructions may run on the computer device shown in FIG. 11. The memory of the computer device may store various program modules that form the sideband suppression apparatus, for example, the target baseband signal obtaining module 1002, the target signal related parameter obtaining module 1004, the target sideband suppression parameter obtaining module 1006, the correction processing module 1008, and the modulation module 1010 shown in FIG. 10. A computer-readable instruction formed by the program modules causes a processor to perform the steps of the sideband suppression method in the embodiments of this application described in this specification.

For example, the computer device shown in FIG. 11 may obtain a target baseband signal by using the target baseband signal obtaining module 1002 in the sideband suppression apparatus shown in FIG. 10. The computer device may obtain a target signal related parameter corresponding to the target baseband signal by using the target signal related parameter obtaining module 1004, the target signal related parameter includes at least one of a signal characteristic parameter corresponding to the target baseband signal or a signal characteristic parameter of a carrier signal corresponding to the target baseband signal. The computer device may obtain a corresponding target sideband suppression parameter based on the target signal related parameter by using the target sideband suppression parameter obtaining module 1006. The computer device may perform signal correction on the target baseband signal based on the target sideband suppression parameter by using the correction processing module 1008, to obtain a corrected target baseband signal, the target sideband suppression parameter is used for suppressing a power of a first suppression sideband corresponding to the target baseband signal. The modulation module 1010 inputs the corrected target baseband signal to a modulator for signal modulation, to obtain a target modulation signal corresponding to the target baseband signal.

In some embodiments, a computer device is provided, including a memory and a processor. The memory stores computer-readable instructions, the computer-readable instructions, when executed by the processor, cause the processor to perform the steps of the foregoing sideband suppression method. Herein, the steps of the sideband suppression method may be the steps of the sideband suppression method in the foregoing embodiments.

In some embodiments, a computer-readable storage medium is provided, storing computer-readable instructions. The computer-readable instructions, when executed by the processor, cause the processor to perform the steps in the foregoing sideband suppression method. Herein, the steps of the sideband suppression method may be the steps of the sideband suppression method in the foregoing embodiments.

In some embodiments, a computer program product or a computer program is provided. The computer program product or the computer program includes computer instructions, and the computer instructions are stored in a computer-readable storage medium. The processor of the computer device reads the computer instructions from the computer-readable storage medium, and the processor executes the computer instructions, to cause the computer device to perform the steps in the method embodiments.

It is to be understood that although the steps in the flowcharts of the embodiments of this application are displayed in sequence according to arrows, the steps are not necessarily performed in the sequence indicated by the arrows. Unless otherwise explicitly specified in this application, execution of the steps is not strictly limited, and the steps may be performed in other sequences. In addition, at least some of the steps in the foregoing embodiments may include multiple substeps or multiple stages. These substeps or stages are not necessarily completed at the same moment, but may be performed at different moments. Besides, these substeps or stages may not be necessarily performed sequentially, but may be performed in turn or alternately with other steps or at least some of substeps or stages of other steps.

A person of ordinary skill in the art may understand that all or some of the procedures of the methods of the foregoing embodiments may be implemented by computer-readable instructions instructing relevant hardware. The computer-readable instructions may be stored in a non-volatile computer-readable storage medium. When the computer-readable instructions are executed, the procedures of the embodiments of the foregoing methods may be included. References to the memory, the storage, the database, or other medium used in the embodiments provided in this application may all include a non-volatile or a volatile memory. The non-volatile memory may include a read-only memory (ROM), a programmable ROM (PROM), an electrically programmable ROM (EPROM), an electrically erasable programmable ROM (EEPROM), or a flash memory. The volatile memory may include a random access memory (RAM) or an external high-speed cache. By way of description rather than limitation, the RAM may be obtained in multiple forms, such as a static RAM (SRAM), a dynamic RAM (DRAM), a synchronous DRAM (SDRAM), a double data rate SDRAM (DDR SDRAM), an enhanced SDRAM (ESDRAM), a Synchlink DRAM (SLDRAM), a Rambus direct RAM (RDRAM), a direct Rambus dynamic RAM (DRDRAM), and a Rambus dynamic RAM (RDRAM).

The technical features in the foregoing embodiments may be randomly combined. For concise description, not all possible combinations of the technical features in the embodiments are described. However, as long as combinations of the technical features do not conflict with each other, the combinations of the technical features are considered as falling within the scope described in this specification.

The foregoing embodiments show only several implementations of this application and are described in detail, which, however, are not to be construed as a limitation to the patent scope of this application. For a person of ordinary skill in the art, several transformations and improvements can be made without departing from the idea of this application. These transformations and improvements belong to the protection scope of this application. Therefore, the protection scope of this application is subject to the protection scope of the appended claims.

## Claims

1. A sideband suppression method, performed at a computer device, the method comprising:

   obtaining (S202) a target baseband signal;
   obtaining (S204) a target signal related parameter corresponding to the target baseband signal, the target signal related parameter comprising at least one of a signal characteristic parameter corresponding to the target baseband signal or a signal characteristic parameter of a carrier signal used for carrying the target baseband signal;
   obtaining (S206) a target sideband suppression parameter based on the target signal related parameter;
   performing (S208) signal correction on the target baseband signal based on the target sideband suppression parameter, to obtain a corrected target baseband signal, the target sideband suppression parameter being used for suppressing a power of a first suppression sideband corresponding to the target baseband signal; and
   inputting (S210) the corrected target baseband signal to a modulator for signal modulation, to obtain a target modulation signal corresponding to the target baseband signal; and
   wherein the performing signal correction on the target baseband signal comprises:

   multiplying the target sideband suppression parameter by an initial compensation signal to obtain a target compensation signal, the initial compensation signal being a complex conjugated signal corresponding to the target baseband signal, and a frequency of the initial compensation signal being opposite to a frequency of the target baseband signal, ; and
   the correcting the target baseband signal based on the target compensation signal to obtain the corrected target baseband signal comprises:
   adding the target compensation signal and the target baseband signal to obtain the corrected target baseband signal.

2. The method according to claim 1, wherein the corrected target baseband signal is obtained according to the formula:

$$z(t) = z_0(t) + c \cdot z_0^*(t)$$

wherein $z(t)$ denotes the corrected target baseband signal, $z_0(t)$ denotes the target baseband signal, $c \cdot z_0^*(t)$ denotes the target compensation signal, $z_0^*(t)$ denotes the initial compensation signal and, $c$ denotes the target sideband suppression parameter.

3. The method according to claim 1, wherein the target sideband suppression parameter is obtained from a pre-stored correspondence set of signal related parameters and sideband suppression parameters, the pre-stored correspondence set including sideband suppression parameters that correspond to signal related parameters for different baseband signals and/or carrier signals.

4. The method according to claim 3, wherein the correspondence set is determined by performing a sideband suppression parameter adjusting process comprising:

   obtaining a baseband and carrier signal **characterized by** their signal related parameters;
   performing signal correction processing based on an initial sideband suppression parameter;
   measuring the signal power from an undesired sideband; and
   adjusting the sideband suppression parameter using a minimization algorithm to minimize the signal power from the undesired sideband.

5. The method according to claim 4 wherein the correspondence set is determined by repeating the sideband suppression parameter adjusting process for different values of the signal related parameters of the baseband signal and the carrier signal to build a multi-dimensional correspondence table between sideband suppression parameters and signal related parameters.

6. The method according to claim 5, wherein the sideband suppression parameter is adjusted until a stop condition is reached, wherein the stop condition comprises at least one of the following:

   the change in the sideband suppression parameter between two subsequent iterations is less than a preset change threshold;
   the power on the undesired suppression sideband is less than a preset power threshold; or
   the number of iterations is greater than a preset number.

7. The method according to any preceding claim, wherein the target sideband suppression parameter is obtained by performing interpolation on the pre-stored correspondence set, if there is no sideband suppression parameter in the pre-stored correspondence set for the signal related parameters of the target baseband signal and/or carrier signal.

8. The method according to any preceding claim, wherein the obtaining a target baseband signal comprises:

   obtaining a target baseband signal in a time domain; and
   performing frequency domain transformation on the target baseband signal in the time domain to obtain a target baseband signal in a frequency domain.

9. The method according to claim 1, wherein the correcting the target baseband signal based on the target compensation signal to obtain the corrected target baseband signal comprises:

   performing frequency domain transformation on the target baseband signal in a time domain, to obtain a target baseband signal in a frequency domain;
   correcting the target baseband signal in the frequency domain based on the initial compensation signal, to obtain a corrected baseband signal in the frequency domain; and
   performing time domain transformation on the corrected baseband signal in the frequency domain, to obtain the corrected target baseband signal in the time domain.

10. The method according to claim 1, wherein the target signal related parameter comprises a baseband frequency corresponding to the target baseband signal, a baseband amplitude corresponding to the target baseband signal, and a carrier frequency of the carrier signal corresponding to the target baseband signal, and

the obtaining (S206) a target sideband suppression parameter based on the target signal related parameter comprises:

obtaining the carrier frequency;

obtaining a parameter correspondence set corresponding to the carrier frequency, parameter correspondences comprising a correspondence between a baseband frequency corresponding to a target baseband signal and a sideband suppression parameter, and a correspondence between a baseband amplitude corresponding to the target baseband signal and the sideband suppression parameter; and

obtaining the target sideband suppression parameter from the parameter correspondence set based on the baseband frequency corresponding to the target baseband signal and the baseband amplitude corresponding to the target baseband signal.

11. The method according to claim 10, wherein the inputting (S210) the corrected target baseband signal to a modulator for signal modulation, to obtain a target modulation signal corresponding to the target baseband signal comprises: inputting a real part corresponding to the corrected target baseband signal to an in-phase end of the modulator, inputting an imaginary part corresponding to the corrected target baseband signal to an orthogonal end of the modulator, and performing signal modulation by using the carrier signal of the carrier frequency to obtain the target modulation signal corresponding to the target baseband signal, to modulate a superconducting qubit based on the target modulation signal.

12. A sideband suppression apparatus configured to carry out the method of any preceding claim.

13. A computer device, comprising:

a memory, configured to store computer-readable instructions; and

a processor, configured to execute the computer-readable instructions, to perform steps of the sideband suppression method according to any one of claims 1 to 11.

14. A non-volatile storage medium, storing computer-readable instructions, the computer-readable instructions, when executed by one or more processors, causing the one or more processors to perform steps of the sideband suppression method according to any one of claims 1 to 11.

**Patentansprüche**

1. Seitenbandunterdrückungsverfahren, das an einer Computervorrichtung durchgeführt wird, wobei das Verfahren Folgendes umfasst:

Erhalten (S202) eines Zielbasisbandsignals;

Erhalten (S204) eines zielsignalbezogenen Parameters, der dem Zielbasisbandsignal entspricht, wobei der zielsignalbezogene Parameter mindestens einen von einem signalcharakteristischen Parameter, der dem Zielbasisbandsignal entspricht, oder einem signalcharakteristischen Parameter eines Trägersignals, das zum Transportieren des Zielbasisbandsignals verwendet wird, umfasst;

Erhalten (S206) eines Zielseitenbandunterdrückungsparameters auf Basis des zielsignalbezogenen Parameters;

Durchführen (S208) einer Signalkorrektur am Zielbasisbandsignal auf Basis des Zielseitenbandunterdrückungsparameters, um ein korrigiertes Zielbasisbandsignal zu erhalten, wobei der Zielseitenbandunterdrückungsparameter zum Unterdrücken einer Leistung eines ersten Unterdrückungsseitenbandes, das dem Zielbasisbandsignal entspricht, verwendet wird; und

Eingeben (S210) des korrigierten Zielbasisbandsignals für eine Signalmodulation in einen Modulator, um ein Zielmodulationssignal zu erhalten, das dem Zielbasisbandsignal entspricht; und

wobei das Durchführen einer Signalkorrektur am Zielbasisbandsignal Folgendes umfasst:

Multiplizieren des Zielseitenbandunterdrückungsparameters mit einem anfänglichen Kompensationssignal, um ein Zielkompensationssignal zu erhalten, wobei das anfängliche Kompensationssignal ein komplexkonjugiertes Signal ist, das dem Zielbasisbandsignal entspricht, und wobei eine Frequenz des anfänglichen Kompensationssignals einer Frequenz des Zielbasisbandsignals entgegengesetzt ist; und

das Korrigieren des Zielbasisbandsignals auf Basis des Zielkompensationssignals, um das korrigierte Zielbasisbandsignal erhalten, umfasst Folgendes:
Addieren des Zielkompensationssignals und des Zielbasisbandsignals, um das korrigierte Zielbasisbandsignal erhalten.

2. Verfahren nach Anspruch 1, wobei das korrigierte Zielbasisbandsignal gemäß der folgenden Formel erhalten wird:

$$z(t) = z_0(t) + c \cdot z_0^*(t)$$

wobei $z(t)$ das korrigierte Zielbasisbandsignal bezeichnet, $z_0(t)$ das Zielbasisbandsignal bezeichnet, $c \cdot z_0^*(t)$ das Zielkompensationssignal bezeichnet, $z_0^*(t)$ das anfängliche Kompensationssignal bezeichnet und $c$ den Zielseitenbandunterdrückungsparameter bezeichnet.

3. Verfahren nach Anspruch 1, wobei der Zielseitenbandunterdrückungsparameter von einem vorab gespeicherten Entsprechungssatz von signalbezogenen Parametern und Seitenbandunterdrückungsparametern erhalten wird, wobei der vorab gespeicherte Entsprechungssatz Seitenbandunterdrückungsparameter beinhaltet, die signalbezogenen Parametern für verschiedene Basisbandsignale und/oder Trägersignale entsprechen.

4. Verfahren nach Anspruch 3, wobei der Entsprechungssatz durch Durchführen eines Seitenbandunterdrückungsparameteranpassungsprozesses bestimmt wird, der Folgendes umfasst:

Erhalten eines Basisbandes und eines Trägersignals, die durch ihre signalbezogenen Parameter gekennzeichnet sind;
Durchführen einer Signalkorrekturverarbeitung auf Basis eines anfänglichen Seitenbandunterdrückungsparameters;
Messen der Signalleistung von einem unerwünschten Seitenband; und
Anpassen des Seitenbandunterdrückungsparameters unter Verwendung eines Minimierungsalgorithmus, um die Signalleistung vom unerwünschten Seitenband zu minimieren.

5. Verfahren nach Anspruch 4, wobei der Entsprechungssatz durch Wiederholen des Seitenbandunterdrückungsparameteranpassungsprozesses für verschiedene Werte der signalbezogenen Parameter des Basisbandsignals und des Trägersignals bestimmt wird, um eine mehrdimensionale Entsprechungstabelle zwischen Seitenbandunterdrückungsparametern und signalbezogenen Parametern aufzubauen.

6. Verfahren nach Anspruch 5, wobei der Seitenbandunterdrückungsparameter angepasst wird, bis eine Stoppbedingung erreicht ist, wobei die Stoppbedingung mindestens eines von Folgendem umfasst:

die Änderung des Seitenbandunterdrückungsparameters zwischen zwei aufeinanderfolgenden Wiederholungen ist kleiner als ein voreingestellter Änderungsschwellwert;
die Leistung am unerwünschten Unterdrückungsseitenband ist kleiner als ein voreingestellter Leistungsschwellwert; oder
die Anzahl von Wiederholungen ist größer als eine voreingestellte Anzahl.

7. Verfahren nach einem der vorhergehenden Ansprüche, wobei der Zielseitenbandunterdrückungsparameter durch Durchführen einer Interpolation am vorab gespeicherten Entsprechungssatz erhalten wird, wenn im vorab gespeicherten Entsprechungssatz für die signalbezogenen Parameter des Zielbasisbandsignals und/oder des Trägersignals kein Seitenbandunterdrückungsparameter vorhanden ist.

8. Verfahren nach einem der vorhergehenden Ansprüche, wobei das Erhalten eines Zielbasisbandsignals Folgendes umfasst:

Erhalten eines Zielbasisbandsignals in einer Zeitdomäne; und
Durchführen einer Frequenzdomänenumwandlung am Zielbasisbandsignal in der Zeitdomäne, um ein Zielbasisbandsignal in einer Frequenzdomäne zu erhalten.

9. Verfahren nach Anspruch 1, wobei das Korrigieren des Zielbasisbandsignals auf Basis des Zielkompensationssignals, um das korrigierte Zielbasisbandsignal zu erhalten, Folgendes umfasst:

Durchführen einer Frequenzdomänenumwandlung am Zielbasisbandsignal in einer Zeitdomäne, um ein Zielbasisbandsignal in einer Frequenzdomäne zu erhalten;

Korrigieren des Zielbasisbandsignals in der Frequenzdomäne auf Basis des anfänglichen Kompensationssignals, um ein korreliertes Basisbandsignal in der Frequenzdomäne zu erhalten; und

Durchführen einer Zeitdomänenumwandlung am korrigierten Basisbandsignal in der Frequenzdomäne, um das korrigierte Zielbasisbandsignal in der Zeitdomäne zu erhalten.

10. Verfahren nach Anspruch 1, wobei der zielsignalbezogene Parameter eine Basisbandfrequenz, die dem Zielbasisbandsignal entspricht, eine Basisbandamplitude, die dem Zielbasisbandsignal entspricht, und eine Trägerfrequenz des Trägersignals umfasst, die dem Zielbasisbandsignal entspricht, und

das Erhalten (S206) eines Zielseitenbandunterdrückungsparameters auf Basis des zielsignalbezogenen Parameters umfasst Folgendes:

Erhalten der Trägerfrequenz;

Erhalten eines Parameterentsprechungssatzes, der der Trägerfrequenz entspricht, wobei Parameterentsprechungen eine Entsprechung zwischen einer Basisbandfrequenz, die einem Zielbasisbandsignal entspricht, und einem Seitenbandunterdrückungsparameter und eine Entsprechung zwischen einer Basisbandamplitude, die dem Zielbasisbandsignal entspricht, und dem Seitenbandunterdrückungsparameter umfassen; und

Erhalten des Zielseitenbandunterdrückungsparameters vom Parameterentsprechungssatz auf Basis der Basisbandfrequenz, die dem Zielbasisbandsignal entspricht, und der Basisbandamplitude, die dem Zielbasisbandsignal entspricht.

11. Verfahren nach Anspruch 10, wobei das Eingeben (S210) des korrigierten Zielbasisbandsignals für eine Signalmodulation in einen Modulator, um ein Zielmodulationssignal zu erhalten, das dem Zielbasisbandsignal entspricht, Folgendes umfasst:

Eingeben eines realen Teils, der dem korrigierten Zielbasisbandsignal entspricht, in ein In-Phase-Ende des Modulators, Eingeben eines imaginären Teils, der dem korrigierten Zielbasisbandsignal entspricht, in ein orthogonales Ende des Modulators und Durchführen einer Signalmodulation unter Verwendung des Trägersignals der Trägerfrequenz, um das Zielmodulationssignal zu erhalten, das dem Zielbasisbandsignal entspricht, um auf Basis des Zielmodulationssignals ein supraleitendes Qubit zu modulieren.

12. Seitenbandunterdrückungseinrichtung, die dazu ausgelegt ist, das Verfahren von einem der vorhergehenden Ansprüche umzusetzen.

13. Computervorrichtung, die Folgendes umfasst:

einen Speicher, der dazu ausgelegt ist, computerlesbare Anweisungen zu speichern; und

einen Prozessor, der dazu ausgelegt ist, die computerlesbaren Anweisungen auszuführen, um Schritte des Seitenbandunterdrückungsverfahrens nach einem der Ansprüche 1 bis 11 durchzuführen.

14. Nichtflüchtiges Speichermedium, auf dem computerlesbare Anweisungen gespeichert sind, wobei die computerlesbaren Anweisungen, wenn sie von einem oder mehreren Prozessoren ausgeführt werden, den einen oder die mehreren Prozessoren veranlassen, Schritte des Seitenbandunterdrückungsverfahrens nach einem der Ansprüche 1 bis 11 durchzuführen.

**Revendications**

1. Procédé de suppression de bande latérale réalisé sur un dispositif informatique, le procédé comprenant :

l'obtention (S202) d'un signal de bande de base cible ;

l'obtention (S204) d'un paramètre lié au signal cible correspondant au signal de bande de base cible, le paramètre lié au signal cible comprenant au moins un parmi un paramètre de caractéristique de signal correspondant au signal de bande de base cible ou un paramètre de caractéristique de signal d'un signal de porteuse utilisé pour transporter le signal de bande de base cible ;

l'obtention (S206) d'un paramètre de suppression de bande latérale cible en fonction du paramètre lié au signal cible ;

effectuer (S208) une correction de signal sur le signal de bande de base cible en fonction du paramètre de suppression de bande latérale cible afin d'obtenir un signal de bande de base cible corrigé, le paramètre de suppression de bande latérale cible étant utilisé pour supprimer une puissance d'une première bande latérale de suppression correspondant au signal de bande de base cible ; et

l'entrée (S210) du signal de bande de base cible corrigé dans un modulateur pour une modulation de signal afin d'obtenir un signal de modulation cible correspondant au signal de bande de base cible ; et

dans lequel la réalisation d'une correction de signal sur le signal de bande de base cible comprend :

la multiplication du paramètre de suppression de bande latérale cible par un signal de compensation initial afin d'obtenir un signal de compensation cible, le signal de compensation initial étant un signal conjugué complexe correspondant au signal de bande de base cible, et une fréquence du signal de compensation initial étant opposée à une fréquence du signal de bande de base cible ; et

la correction du signal de bande de base cible en fonction du signal de compensation cible afin d'obtenir le signal de bande de base cible corrigé comprend :

l'addition du signal de compensation cible et du signal de bande de base cible afin d'obtenir le signal de bande de base cible corrigé.

2. Procédé selon la revendication 1, dans lequel le signal de bande de base cible corrigé est obtenu selon la formule :

$$z(t) = Z_0(t) + c \cdot z_0^*(t)$$

dans lequel $z(t)$ désigne le signal de bande de base cible corrigé, $z_0(t)$ désigne le signal de bande de base cible, $c \cdot z_0^*(t)$ désigne le signal de compensation cible, $z_0^*(t)$ désigne le signal de compensation initial et, c désigne le paramètre de suppression de bande latérale cible.

3. Procédé selon la revendication 1, dans lequel le paramètre de suppression de bande latérale cible est obtenu à partir d'un ensemble de correspondances pré-stockées de paramètres liés au signal et de paramètres de suppression de bande latérale, l'ensemble de correspondances pré-stockées comportant des paramètres de suppression de bande latérale qui correspondent à des paramètres liés au signal pour différents signaux de bande de base et/ou signaux de porteuse.

4. Procédé selon la revendication 3, dans lequel l'ensemble de correspondances est déterminé en effectuant un processus d'ajustement de paramètres de suppression de bande latérale comprenant :

l'obtention d'un signal de bande de base et d'un signal de porteuse **caractérisés par** leurs paramètres liés au signal ;

la réalisation d'un traitement de correction de signal en fonction d'un paramètre de suppression de bande latérale initial ;

la mesure de la puissance de signal provenant d'une bande latérale indésirable ; et

l'ajustement du paramètre de suppression de bande latérale à l'aide d'un algorithme de minimisation afin de minimiser la puissance de signal provenant de la bande latérale indésirable.

5. Procédé selon la revendication 4, dans lequel l'ensemble de correspondances est déterminé en répétant le processus d'ajustement de paramètres de suppression de bande latérale pour différentes valeurs des paramètres liés au signal du signal de bande de base et du signal de porteuse afin de construire un tableau de correspondances multidimensionnel entre les paramètres de suppression de bande latérale et les paramètres liés au signal.

6. Procédé selon la revendication 5, dans lequel le paramètre de suppression de bande latérale est ajusté jusqu'à ce qu'une condition d'arrêt soit atteinte, dans lequel la condition d'arrêt comprend au moins l'un des cas suivants :

le changement du paramètre de suppression de bande latérale entre deux itérations consécutives est inférieur à un seuil de changement prédéfini ;

la puissance sur la bande latérale de suppression indésirable est inférieure à un seuil de puissance prédéfini ; ou

le nombre d'itérations est supérieur à un nombre prédéfini.

7. Procédé selon l'une des revendications précédentes, dans lequel le paramètre de suppression de bande latérale cible est obtenu en effectuant une interpolation sur l'ensemble de correspondances pré-stockées s'il n'y a pas de paramètre de suppression de bande latérale dans l'ensemble de correspondances pré-stockées pour les paramètres liés au signal du signal de bande de base cible et/ou du signal de porteuse.

8. Procédé selon l'une des revendications précédentes, dans lequel l'obtention d'un signal de bande de base cible comprend :

l'obtention d'un signal de bande de base cible dans un domaine temporel ; et
la réalisation d'une transformation dans le domaine fréquentiel sur le signal de bande de base cible dans le domaine temporel afin d'obtenir un signal de bande de base cible dans un domaine fréquentiel.

9. Procédé selon la revendication 1, dans lequel la correction du signal de bande de base cible en fonction du signal de compensation cible afin d'obtenir le signal de bande de base cible corrigé comprend :

la réalisation d'une transformation dans le domaine fréquentiel sur le signal de bande de base cible dans un domaine temporel, afin d'obtenir un signal de bande de base cible dans un domaine fréquentiel ;
la correction du signal de bande de base cible dans le domaine fréquentiel en fonction du signal de compensation initial, afin d'obtenir un signal de bande de base corrigé dans le domaine fréquentiel ; et
la réalisation d'une transformation dans le domaine temporel sur le signal de bande de base corrigé dans le domaine fréquentiel afin d'obtenir le signal de bande de base cible corrigé dans le domaine temporel.

10. Procédé selon la revendication 1, dans lequel le paramètre lié au signal cible comprend une fréquence de bande de base correspondant au signal de bande de base cible, une amplitude de bande de base correspondant au signal de bande de base cible et une fréquence de porteuse du signal de porteuse correspondant au signal de bande de base cible, et

l'obtention (S206) d'un paramètre de suppression de bande latérale cible en fonction du paramètre lié au signal cible comprend :

l'obtention de la fréquence de porteuse ;
l'obtention d'un ensemble de correspondances de paramètres correspondant à la fréquence de porteuse, les correspondances de paramètres comprenant une correspondance entre une fréquence de bande de base correspondant à un signal de bande de base cible et un paramètre de suppression de bande latérale, et une correspondance entre une amplitude de bande de base correspondant au signal de bande de base cible et le paramètre de suppression de bande latérale ; et
l'obtention du paramètre de suppression de bande latérale cible à partir de l'ensemble de correspondances de paramètres en fonction de la fréquence de bande de base correspondant au signal de bande de base cible et de l'amplitude de bande de base correspondant au signal de bande de base cible.

11. Procédé selon la revendication 10, dans lequel l'entrée (S210) du signal de bande de base cible corrigé dans un modulateur pour une modulation de signal afin d'obtenir un signal de modulation cible correspondant au signal de bande de base cible comprend :
l'entrée d'une partie réelle correspondant au signal de bande de base cible corrigé dans une extrémité en phase du modulateur, l'entrée d'une partie imaginaire correspondant au signal de bande de base cible corrigé dans une extrémité orthogonale du modulateur, et la réalisation d'une modulation de signal en utilisant le signal de porteuse de la fréquence de porteuse afin d'obtenir le signal de modulation cible correspondant au signal de bande de base cible, afin de moduler un qubit supraconducteur en fonction du signal de modulation cible.

12. Appareil de suppression de bande latérale configuré pour mettre en œuvre le procédé selon l'une des revendications précédentes.

13. Dispositif informatique, comprenant :

une mémoire configurée pour stocker des instructions lisibles par ordinateur ; et
un processeur configuré pour exécuter les instructions lisibles par ordinateur, pour effectuer les étapes du procédé de suppression de bande latérale selon l'une des revendications 1 à 11.

14. Support de stockage non volatile stockant des instructions lisibles par ordinateur, les instructions lisibles par ordinateur, lorsqu'elles sont exécutées par un ou plusieurs processeurs, amenant les un ou plusieurs processeurs à effectuer les étapes du procédé de suppression de bande latérale selon l'une des revendications 1 à 11.

FIG. 1

S202

Obtain a target baseband signal

S204

Obtain a target signal correlated parameter corresponding to the target baseband signal, the target signal correlated parameter including at least one of a signal characteristic parameter corresponding to the target baseband signal or a signal characteristic parameter of a carrier signal corresponding to the target baseband signal

S206

Obtain a corresponding target sideband suppression parameter based on the target signal correlated parameter

S208

Perform signal correction processing on the target baseband signal based on the target sideband suppression parameter, to obtain a corrected target baseband signal, the target sideband suppression parameter being used for suppressing a power of a first suppression sideband corresponding to the target baseband signal

S210

Input the corrected target baseband signal to a modulator for signal modulation, to obtain a target modulation signal corresponding to the target baseband signal

FIG. 2

Obtain a parameter correspondence set, the parameter correspondence set including one or more parameter correspondences, and the one or more parameter correspondences including a correspondence between a signal correlated parameter and a sideband suppression parameter

⌒ S302

Obtain a signal correlated parameter corresponding to the target signal correlated parameter in the parameter correspondence set as a reference signal correlated parameter

⌒ S304

Obtain the target sideband suppression parameter corresponding to the target signal correlated parameter based on a sideband suppression parameter corresponding to the reference signal correlated parameter in the parameter correspondence set

⌒ S306

FIG. 3

S402

Obtain a reference baseband signal corresponding to the reference signal correlated parameter

S404

Obtain a current sideband suppression parameter, and perform signal correction processing on the reference baseband signal based on the current sideband suppression parameter, to obtain a corrected reference baseband signal

S406

Input the corrected reference baseband signal to the modulator for modulation, to obtain a reference modulation signal

S408

Adjust the current sideband suppression parameter based on a power of the reference modulation signal on a second suppression sideband, to obtain the sideband suppression parameter corresponding to the reference signal correlated parameter

FIG. 4

S502

Obtain a given signal correlated parameter, and obtain a reference baseband signal based on the given signal correlated parameter

S504

Obtain a current sideband suppression parameter, and perform signal correction processing on the reference baseband signal based on the current sideband suppression parameter, to obtain a corrected reference baseband signal

S506

Input the corrected reference baseband signal to a modulator for modulation, to obtain a modulated training baseband signal

S508

Obtain a signal power at a second suppression sideband

S512

Adjust the current sideband suppression parameter with a purpose of decreasing the power of the reference modulation signal on the second suppression sideband, to obtain an updated current sideband suppression parameter

S510

Determine whether the signal power at the second suppression sideband is less than a preset power threshold

No

Yes

S514

Record a correspondence between the signal correlated parameter and the sideband suppression parameter

FIG. 5

FIG. 6

Perform FFT on a time
domain signal z[n] to
obtain a frequency
spectrum Z[n] and a
frequency f[n]

Calculate an amplitude
|Z[n]|

Whether both -f[n]
and |Z[-n]| are in calibration data
sets Gf and GA

N

Y

Take out a compensation
coefficient $c$

Perform interpolate
according to existing
compensation coefficient
data to calculate $c$

Record a compensation
coefficient c[n]

Calculate
Z'[n]=Z[n]+c[n]*Z[-n]

Calculate IFFT(Z') to
obtain z'

Output Re[z'] as I,
and output Im[z'] as Q

FIG. 7

FIG. 8

FIG. 9A

FIG. 9B

_1002_

Target baseband signal
obtaining module

_1004_

Target signal
correlated parameter
obtaining module

_1006_

Target sideband
suppression parameter
obtaining module

_1008_

Correction processing
module

_1010_

Modulation module

FIG. 10

Processor

Operating system

Computer-readable
instruction

Non-volatile storage
medium

Computer-readable
instruction

Internal memory

Memory

Network interface

Computer device

FIG. 11

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202010078701
- US 2004082305 A1
- CN 101540626 A